(19) Europäisches Patentamt
European Patent Office
Office européen des brevets

(11) EP 1 210 772 B1

# (12) FASCICULE DE BREVET EUROPEEN

(45) Date de publication et mention de la délivrance du brevet:
**03.09.2003 Bulletin 2003/36**

(21) Numéro de dépôt: **00960825.8**

(22) Date de dépôt: **07.09.2000**

(51) Int Cl.[7]: **H03M 1/10**
// H03M1:12

(86) Numéro de dépôt international:
**PCT/FR00/02474**

(87) Numéro de publication internationale:
**WO 01/018969 (15.03.2001 Gazette 2001/11)**

(54) **PROCEDE ET DISPOSITIF DE TEST INTEGRE POUR UN CONVERTISSEUR ANALOGIQUE-NUMERIQUE**

INTEGRIERTE TESTANORDNUNG FÜR EINEN ANALOG-DIGITAL-WANDLER UND ENTSPRECHENDES VERFAHREN

METHOD AND DEVICE FOR INTEGRATED TESTING FOR AN ANALOG-TO-DIGITAL CONVERTER

(84) Etats contractants désignés:
**AT BE CH CY DE DK ES FI FR GB GR IE IT LI LU MC NL PT SE**

(30) Priorité: **09.09.1999 FR 9911304**

(43) Date de publication de la demande:
**05.06.2002 Bulletin 2002/23**

(73) Titulaire: **CENTRE NATIONAL DE LA RECHERCHE SCIENTIFIQUE (CNRS)
75016 Paris (FR)**

(72) Inventeurs:
- **RENOVELL, Michel
F-34980 Montferrier/Lez (FR)**
- **AZAIS, Florence
F-37980 Conbaillaux (FR)**
- **BERNARD, Serge
F-07270 Lamastre (FR)**
- **BERTRAND, Yves
F-34090 Montpellier (FR)**

(74) Mandataire: **Jacobson, Claude
Cabinet Lavoix
2, Place d'Estienne d'Orves
75441 Paris Cedex 09 (FR)**

(56) Documents cités:
**EP-A- 0 336 715**

- **RACZKOWYCZ J ET AL: "Embedded ADC characterization techniques using a BIST structure, an ADC model and histogram data" MICROELECTRONICS JOURNAL,GB,MACKINTOSH PUBLICATIONS LTD. LUTON, vol. 27, no. 6, 1 septembre 1996 (1996-09-01), pages 539-549, XP004007233 ISSN: 0026-2692**
- **MOK F K Y ET AL: "STRECH: SELF TESTING RELIABILITY EVALUATION CHIP" PROCEEDINGS OF THE CUSTOM INTEGRATED CIRCUITS CONFERENCE,US,NEW YORK, IEEE, vol. CONF. 15, 1993, pages 30.4.1-30.4.4, XP000409779**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

EP 1 210 772 B1

Printed by Jouve, 75001 PARIS (FR)

## Description

La présente invention concerne les convertisseurs analogique-numérique et se rapporte plus particulièrement à l'intégration d'un module d'auto-test qui permet de mesurer les caractéristiques fonctionnelles du convertisseur. telles que le décalage, le gain. les non-linéarités et autres, en utilisant le principe du test par histogramme.

En ce qui concama le test des convertisseurs analogique-numérique, les industriels utilisent principalement deux méthodes à savoir le test par histogramme et le test par Transformée de Fourier Rapide (TFR).

La mise en oeuvre de ces méthodes nécessite un équipement de test externe performant et très coûteux sous la forme d'un testeur industriel.

Une solution classique pour diminuer le coût de ce test externe consiste à intégrer des modules de test à l'intérieur même du circuit.

Il est admis que ce type de solution est économiquement viable dans la mesure où la surface des modules ajoutés ne représente que 10 à 15% de la surface originale du circuit.

L'intégration d'un dispositif de test par histogramme dans sa forme classique pose un problème dans la mesure où la surface des modules de test ajoutée est excessive compte tenu du volume extrêmement important de données à stocker d'une part, et des opérations complexes à réaliser pour permettre l'exploitation d'autre part.

EP 0 336 715 décrit l'architecture d'un convertisseur analogique-numérique comprenant une logique numérique pour accumuler des données de densité de codes destinées à être utilisées pour caractériser le convertisseur. Les données accumulées par cette logique numérique sont ensuite transmises à un ordinateur pour être traitées.

Le document de J. Raczkowycz et al., "Embedded ADC characterization techniques using a BIST structure, an ADC model and histogram data", Microelectronics Journal, GB, Mackintosh Publications Ltd., Luton, vol. 27, n° 6, 1er septembre 1996, pages 539-549, XP004007233, décrit une technique de test pour caractériser un convertisseur analogique-numérique. Cette technique utilise une mémoire RAM et une cellule d'incrémentation embarquées avec le convertisseur analogique-numérique de manière à réduire le nombre d'informations échangées entre le convertisseur analogique à tester et un appareil de test externe.

Le document de Franck K.Y. MOK et al., "Strech: Self testing reliability evaluation chip", Proceedings of the Custom Integrated Circuits Conférence, US, New York, IEEE vol. Conf. 15, 1993, pages 30.4.1-30.4.4, XP000409779, décrit un circuit ASIC équipé d'une section numérique apte à déterminer une non-linéarité différentielle à partir d'un histogramme de données de codes.

L'invention vise à remédier à cet inconvénient en redéfinissant la technique de test par histogramme de manière à n'avoir qu'un nombre réduit d'informations à stocker sur le circuit intégré et à évaluer les caractéristiques du convertisseur à partir d'opérations simples.

Elle vise également à réaliser un module de test Intégré occupant une faible surface de manière à rendre la solution du test par histogramme économiquement intéressante.

Elle a donc pour objet un procédé de test par histogramme d'un convertisseur analogique-numérique, consistant à décomposer dans le temps, l'accumulation et l'exploitation de l'histogramme, caractàrisé en ce qu'il fait appel à des ressources communes pour traiter successivement les caractéristiques fonctionnelles du convertisseur analogique-numérique et en ce qu'il consiste à initialiser et configurer successivement lesdites ressources en vue de les adapter à la détermination de chacune des caractéristiques fonctionnelles dudit convertisseur.

L'invention a également pour objet un dispositif d'auto-test d'un convertisseur analogique-numérique pour la mise en oeuvre du procédé défini ci-dessus, comprenant des moyens d'application au convertisseur de signaux de test, et des moyens d'analyse, caractérisé en ce que lesdits moyens d'analyse comportent des ressources communes intégrées avec le convertisseur et configurables pour déterminer successivement des caractéristiques fonctionnelles du convertisseur et des moyens de configuration desdits moyens d'analyse en vue de les adapter aux caractéristiques à déterminer.

Selon d'autres caractéristiques, le dispositif comporte un compteur d'un code de référence - comparateur connecté à la sortie du convertisseur analogique-numérique, un compteur/décompteur d'exploitation et de stockage dont la sortie délivre des signaux relatifs aux caractéristiques fonctionnelles du convertisseur et un contrôleur de gestion des phases de test au moyen dudit compteur-comparateur et dudit compteur-décompteur.

L'invention sera mieux comprise à la lecture de la description qui va suivre, donnée uniquement à titre d'exemple et faite en se référant aux dessins annexés, sur lesquels :

- la Fig.1 est un schéma synoptique d'un convertisseur analogique-numérique avec un circuit de test incorporé à son circuit intégré;
- la Fig.2 est un schéma synoptique plus détaillé d'un mode de réalisation d'un module d'analyse suivant l'invention;
- la Fig.3 est une représentation plus détaillée du compteur du schéma de la Fig.2;
- la Fig.4 est une représentation plus détaillée du compteur/décompteur du schéma de la Fig.2;
- la Fig.5 est un schéma détaillée d'un organigramme illustrant le calcul du décalage, du gain et des non-linéarités à l'aide du module suivant l'invention;

- la Fig.6 est un graphique montrant la détermination du décalage;
- la Fig.7 est un graphique montrant la détermination du gain;
- la Fig.8 représente un algorithme de test des paramètres essentiels du convertisseur;
- la Fig.9 représente un algorithme de calcul du décalage;
- la Fig.10 représente un algorithme de calcul du gain;
- la Fig.11 représente un algorithme de calcul des non-linéarités différentielles; et
- la Fig.12 représente un algorithme de calcul des non-linéarités intégrales.

L'invention porte sur le test intégré des convertisseurs analogique-numérique.

De façon classique, selon une telle solution, il s'agit d'intégrer sur le même silicium que le CAN, un module permettant d'appliquer à l'entrée du convertisseur des stimuli de test et un module permettant d'observer et d'analyser les réponses de sortie du convertisseur.

Un tel agencement est représenté à la figure 1, qui représente un convertisseur analogique-numérique CAN 1 à l'entrée duquel est connecté un multiplexeur 2 ayant une entrée connectée à l'entrée analogique 3 du circuit, une entrée connectée à une ligne 4 d'application d'un signal de test et une entrée reliée à la sortie d'un générateur 5 de stimuli de test.

A sa sortie, le CAN 1 est connecté à un module d'analyse 6 qui comporte une entrée par laquelle il est connecté à la ligne 4 d'application des signaux de test et une sortie de test 7, tandis que le CAN comporte une sortie numérique 8 indépendante.

Sachant qu'il existe déjà des solutions développées pour la génération de stimuli, l'invention se rapporte plus spécifiquement au module d'analyse en vue de favoriser la possibilité d'intégration au CAN de la technique de test par histogramme.

Le test par histogramme est basé sur une analyse statistique de la fréquence d'apparition des codes en sortie du convertisseur à tester.

En effet, un CAN de n bits possède $2^n$ codes possibles à sa sortie.

Lorsqu'un stimulus de test est appliqué à l'entrée du CAN 1, chaque code doit apparaître un nombre donné de fois.

Le principe de l'histogramme consiste donc à compter le nombre de fois H(i), que chaque code i apparaît effectivement.

Ces fréquences d'apparition H(i) sont ensuite exploitées pour déterminer les caractéristiques fonctionnelles (décalage, gain, non-linéarités et autres) du convertisseur.

En externe, de manière classique, ce type de test nécessite des ressources matérielles importantes.

En effet, pour effectuer le test d'un CAN de n bits, il est nécessaire d'utiliser $2^{n+1}$ mots de mémoire pour le stockage de l'histogramme et un processeur de signal numérique DSP ou un microprocesseur pour son exploitation.

L'intégration directe de cette technique représente par conséquent, une solution inacceptable puisque la surface occupée par la mémoire et le microprocesseur est largement supérieure à celle du convertisseur lui-même.

De manière à rendre économiquement viable l'intégration du test par histogramme, on redéfinit la technique pour diminuer les ressources nécessaires à son fonctionnement tout en préservant ses performances.

L'idée fondamentale de l'invention consiste à décomposer dans le temps, l'accumulation et l'exploitation de l'histogramme.

En effet, le test par histogramme considéré comme un algorithme, peut être décomposé selon deux dimensions : l'une temporelle, l'autre spatiale.

Sous la contrainte d'une surface minimale imposée pour le module de test intégré au convertisseur, la solution suivant l'invention consiste à privilégier la décomposition temporelle de l'algorithme.

L'invention est donc basée sur l'accumulation code à code de l'histogramme et sur un traitement séquentiel des informations relatives à chaque code.

Pour des contraintes de surface moins strictes, il est possible de calculer et d'exploiter l'histogramme par groupe de codes (2 codes par 2 codes...).

A un instant donné du traitement séquentiel, les ressources matérielles requises ne concernent donc que le code en cours.

En effet, après traitement d'un code, ces ressources sont libérées et rendues disponibles pour le code suivant.

De plus, une seconde décomposition temporelle consiste à ne déterminer qu'une seule des caractéristiques fonctionnelles à la fois.

L'analyse est par conséquent décomposée en trois phases.

1) Détermination du décalage,
2) Détermination du gain,

3) Détermination des non-linéarités.

Lors de l'application de ces trois phases, on a choisi un stimulus d'entrée triangulaire permettant de minimiser les ressources de calcul nécessaires à l'exploitation de l'histogramme.

Dans la première phase, seuls les codes extrêmes sont exploités pour déterminer le décalage.

$$\text{Décalage} = k_1\ [p(2^n) - p(1)]$$

$k_1$ étant une constante connue.

Dans la deuxième phase, seule une partie des codes du milieu sont exploités séquentiellement pour déterminer le gain.

$$\text{Gain} = k_2 \sum_{i=1}^{N} p(i + A)$$

$k_2$ étant une constante connue,

A étant une constante connue dépendant du nombre de bits du convertisseur.

Dans la troisième phase, chaque code est traité séquentiellement. On obtient ainsi la non-linéarité différentielle NLD(i) associée à chaque code i.

$$NLD(i) = k_3\ p(i)$$

$k_3$ étant une constante connue.

De plus, le cumul séquentiel de NLD permet d'obtenir la non-linéarité intégrale NLI(i) associée à chaque code i:

$$NLI(i) = \sum_{j=1}^{i} NLD(j)$$

Finalement, le bilan des ressources matérielles nécessaires à l'application de la technique suivant l'invention est le suivant.

La détection de la présence d'un code en sortie peut être réalisée à l'aide d'un simple comparateur et d'un compteur pour positionner le code de référence.

Les différents traitements ne font intervenir que des opérations simples qui peuvent être implantées à l'aide d'un compteur-décompteur.

La gestion des trois phases de test est assurée par un contrôleur peu complexe.

Le schéma de principe d'une implantation possible d'un module de test suivant l'invention est représenté à la figure 2.

Ce module qui est en fait le module d'analyse du schéma de la figure 1, comporte un compteur-comparateur 10 à n entrées 11 In<7:0> connectées aux sorties correspondantes du CAN (non représenté) et représentant le code de sortie à 8 bits de celui-ci.

Il comporte en outre une entrée d'effacement ou de mise à zéro 12, une entrée d'horloge 13, une entrée de contrôle 14 et une entrée d'établissement 15.

Il comporte de plus des sorties 16 reliées à trois entrées outB2, outB6, outB8, 17a,17b,17c d'un contrôleur 20 et une sortie 21 reliée à une entrée 22 du contrôleur 20.

Le contrôleur 20 comporte en outre une entrée 23 reliée aux sorties du CAN, une sortie d'effacement 24 reliée à l'entrée 12 du compteur-comparateur 10, une sortie code suivant 25 connectée à l'entrée d'horloge 13, une sortie contrôle 26 connectée à l'entrée de contrôle 14 du circuit 10 et une sortie d'établissement 27 connectée à l'entrée d'établissement 15 du compteur-comparateur 10.

Le contrôleur comporte en outre une entrée d'horloge ck28, une entrée d'effacement clear 29, une entrée de début 30, et une entrée de fin 31.

Il comporte de plus une sortie C1 32 et une sortie C2 33, connectées respectivement à des entrées C1, C2, 34,35 d'un compteur-décompteur 36 et une sortie d'effacement 37 connectée à une entrée effacement 38 du compteur-décompteur 36.

Enfin, le contrôleur 20 comporte une entrée multiple 40 par laquelle il est connecté à des sorties 41 correspondantes du compteur-décompteur 36.

Ce dernier comporte une entrée d'horloge 42 et une sortie multiple 43 S<6:0> qui est la sortie des bascules sur 8 bits plus une sortie de report et représente le code de référence.

Le compteur-comparateur 10 est représenté en détail à la figure 3.

Il est dans le présent exemple réalisé à base d'un compteur à huit bits dont chacun des huit étages comporte un ensemble de portes 45a à 45h auquel est associée une bascule 46a à 46h. Les fonctions compteur ou comparateur de ce circuit sont déterminées par le signal provenant du circuit de contrôle 20 et appliquées à l'entrée de contrôle 14 + report.

La fonction de comparaison est assurée par une porte NON-OU EXCLUSIF 47a dont une entrée est reliée à l'entrée 11 de réception des signaux de sortie du convertisseur analogique-numérique par l'intermédiaire d'un multiplexeur 48a dont une autre entrée est reliée par l'intermédiaire d'une porte NON-ET 49a à la borne Q de la bascule 46b de l'étage suivant.

La sortie de chacune des portes NON-OU EXCLUSIF 47a à 47h est connectée à une entrée correspondante d'une porte NON-ET 50.

La sortie de cette porte constitue la sortie 21 du compteur-comparateur qui délivre le signal Ini-A destiné au contrôleur 20, et qui donne le résultat de la comparaison entre le code de référence et le code de sortie du CAN.

Le compteur-décompteur 36 du circuit de la figure 2 est représenté en détail à la figure 4.

Il comporte six groupes de portes 52a à 52f auxquelles sont associées des bascules correspondantes 53a à 53g.

Chaque groupe de portes tel que le groupe 52a comporte trois portes NON-ET 54a,55a,56a.

La porte 54a a deux entrées connectées respectivement aux entrées 34,35 des signaux $C_2$ et $C_1$.

La porte 55a est une porte à trois entrées dont l'une est reliée à l'entrée 35 du signal $C_2$, dont une seconde entrée est connectée par l'intermédiaire d'un inverseur 57a à une entrée d'une porte OU EXCLUSIF du groupe de portes 52b suivant, et dont une troisième entrée est connectée à la sortie d'une porte NON-ET du groupe de portes 52b.

La troisième porte 56a est une porte à trois entrées dont une première entrée est connectée à la sortie de la porte NON-ET du groupe de portes 52b, dont une seconde entrée est connectée à l'entrée 34 du signal $C_1$ et dont une troisième entrée est connectée à l'entrée de la porte OU EXCLUSIF du groupe de portes 52b suivant.

Les sorties des portes 54a, 55a,56a sont connectées à trois entrées respectives d'une porte NON-ET 58a dont la sortie est reliée à une entrée d'une porte OU EXCLUSIF 59a.

La sortie de la porte 59a est reliée à la borne D de la bascule 53 tandis que l'autre entrée de la porte OU EXCLUSIF est connectée à la borne Q de la bascule 53a.

La borne C de ladite bascule est connectée à l'entrée d'horloge ck 42, tandis que sa borne RN est connectée à la borne d'effacement 38.

Les autres étages du compteur-décompteur sont identiques et ne seront donc pas décrits.

Les signaux Ci et $C_2$ sont par ailleurs appliqués à une porte NON-OU dont la sortie est connectée par l'intermédiaire d'un inverseur 61 à une entrée d'une porte OU EXCLUSIF 62 dont l'autre entrée est reliée à la borne Q d'une bascule 53g supplémentaire. La sortie de la porte 62 est connectée à la borne D de la bascule 53g reliée à la sortie 41 du circuit. La borne Q de la bascule 53g est reliée à la sortie 43, tandis que ses bornes C et RN sont connectées respectivement aux entrées d'horloge et d'effacement 42 et 38.

La technique présentée permet de déterminer les caractéristiques fonctionnelles telles que le décalage, le gain et les non-linéarités d'un convertisseur analogique-numérique.

Ce test dynamique est basé sur une analyse statistique de la fréquence d'apparition H(i) de chaque code i à la sortie d'un CAN de n bits.

L'ensemble du test s'effectue avec une entrée triangulaire à la fréquence maximale de fonctionnement du convertisseur.

Pour ce type de signal, la fréquence d'apparition théorique $H_{thé}$ a la même valeur pour tous les codes $H_{thé} = \frac{N}{2^n}$.

Elle dépend uniquement du nombre N d'échantillons et du nombre n de bits du convertisseur.

On va maintenant décrire en référence aux figures 6 et 7, la détermination du décalage et du gain.

La définition classique de l'erreur de décalage est la suivante. Dans un CAN, l'erreur de décalage est la différence entre les tensions réelle et théorique de l'entrée qui fait commuter le bit de poids le plus faible.

Selon l'invention, le décalage est calculé à l'aide de deux codes extrêmes qui sont les seuls codes modifiés dans le cas d'une erreur de décalage pour un signal triangulaire tel que le signal de la figure 6.

L'erreur a ici un effet linéaire sur la fréquence d'apparition de chaque code.

Par conséquent, on arrive à une expression très simple du décalage exprimé en LSB :

$$\text{Décalage} = \frac{(H(2^n)-H(1)).A.Te.2^n}{Tin.PE} + C \qquad (1)$$

dans laquelle :

A est l'amplitude du signal d'entrée,
Te est la période d'échantillonnage,
Tin est la période du signal d'entrée;
PE est la pleine échelle du convertisseur,
C est une constante connue tenant compte du décalage de la caractéristique idéale.

Si par exemple, on désire mesurer une erreur supérieure à 1 LSB, il faut augmenter l'amplitude du signal d'entrée. En effet, si l'amplitude du signal d'entrée correspond juste à la pleine échelle PE du convertisseur et si le décalage est supérieur à 1 LSB, le code 00....00 ne sera jamais présent à la sortie du convertisseur.

La valeur minimale de l'amplitude d'entrée dépend directement du décalage maximum mesuré.

$$A \geq \text{décalage}_{max} + PE$$

On va maintenant décrire la détermination du gain en référence à la figure 7, qui représenté le pas de quantification en fonction du nombre N d'échantillons pour chaque code.

Si le convertisseur a un gain g différent de 1, son pas de quantification qr est toujours constant, mais il a une valeur g fois plus petite que dans le cas idéal qr=q/g.

Par une étude similaire à celle du décalage, qr peut être obtenu assez facilement :

$$qr = \frac{Ncode.A.fin}{fe} \qquad q = \frac{PE}{2^{n-1}}$$

L'erreur de gain exprimée en LSB peut être déterminée grâce à qr.

$$\text{Erreur de gain} = \frac{qr\text{-q}}{q} = \frac{Ncode.2^{n-1}.A.Te\text{-}PE.Tin}{.PE.Tin} \qquad (2)$$

Dans cette équation, A, Te, Tin, PE et q représentent respectivement l'amplitude du signal d'entrée, la période d'échantillonnage, la période du signal d'entrée, la tension pleine échelle du convertisseur et le pas de quantification idéal.

Cette mesure ne peut être réalisée sur un seul code, car il faut prendre en compte les variations du pas de quantification dues aux non-linéarités du convertisseur.

La moindre erreur de non-linéarité sur le code pris comme référence va être répercutée sur la mesure du gain.

Par conséquent, la mesure va porter sur plusieurs codes différents. La variation du pas de quantification pour un code i est causée par la non-linéarité différentielle de ce code.

Par contre, pour une variation due à plusieurs codes, il est intéressant d'étudier l'influence de l'incertitude sur la non-linéarité intégrale.

On se place dans le cas extrême où la variation du pas de quantification due aux non-linéarités des codes étudiés est égale à la non-linéarité intégrale maximale admise.

Pour une précision de mesure sur le gain de $\Delta g$ et une erreur de non-linéarité intégrale maximum, $NLI_{max}$, le nombre de codes est égal au rapport $NLI_{max}$ par $\Delta g$.

$$\text{Nombre de codes} = \frac{NLI_{max}}{\Delta g}$$

La précision de la mesure du gain est très importante pour la suite parce qu'elle influence toutes les mesures futures.

Par exemple, avec des contraintes assez strictes :

$NLI_{max}$ = 1. LSB et une bonne précision de mesure, soit $\Delta g$ = 0,02 LSB.
Il est nécessaire de calculer la moyenne de l'erreur de gain sur 50 codes.
On va maintenant décrire la détermination des non-linéarités.
On peut définir deux types de non-linéarités:

- les non-linéarités différentielles (NLD)
- les non-linéarités intégrales.

Les non-linéarités différentielles représentent la différence par rapport à un LSB, des valeurs analogiques correspondantes à deux codes successifs.
Dans la présente technique, elles sont déterminées directement à partir de la fréquence d'apparition du code auquel elles se rapportent.

$$\text{NLD (i)} = \frac{H(i)-H_{thé}}{H_{thé}} \qquad (3)$$

avec $H_{thé} = \frac{N}{2^n}$
Les non-linéarités intégrales (NLI) représentent l'écart maximal entre la caractéristique réelle et la droite de transfert idéale.
Elles sont calculées en accumulant les NLD.

$$\text{NLI(i)} = \sum_{j=1}^{i} NLD(j) \qquad (4)$$

On va maintenant décrire en référence à la figure 5, l'algorithme global de la technique suivant l'invention.
On notera que toutes les ressources du système sont réutilisables après chaque initialisation. De ce fait, les ressources globales nécessaires à l'application de la technique de l'invention sont faibles et donc la structure est facilement intégrable à un convertisseur analogique-numérique.
L'algorithme est représenté à la figure 5 sous la forme d'un organigramme.
Il comporte :

- une phase 1 de calcul du décalage,
- une phase 2 de calcul du gain,
- une phase 3 de calcul des non-linéarités différentielles et intégrales.

La phase 1 comprend une étape 70 d'initialisation de toutes les ressources $H_{dec}$ = 0.
Puis, au cours d'une étape 71, on calcule la fréquence d'apparition H(o) du code 0.
Au cours de la phase 72, on calcule la fréquence d'apparition $H(2^n)$ du code $2^n$.
Au cours de l'étape 73, on procède au calcul de $H_{dec} = H(2^n)-H(0)$.
Ces opérations sont réalisées avec les ressources décrites en référence aux figures 2 à 4 programmées pour assurer le calcul du décalage.
Au cours de l'étape 74, on procède à l'initialisation des ressources en vue de la phase 2 de calcul du gain. A l'issue de cette initialisation $H_{gain}$= 0.
Puis, au cours de l'étape 75, on calcule la fréquence d'apparition H(N1) du code N1.
Au cours de l'étape 76, on accumule avec la valeur de gain précédente, $H_{gain}=H_{gain}$ + H(N1).
Au cours de l''étape 77, on procède à l'incrémentation du code de référence N1 : N1=N1+1.
Au cours de l'étape 78, on détermine si N1 < N2.
Dans l'affirmative, on retourne à l'étape 75 de calcul de la fréquence d'apparition H(N1) du code N1.
Dans la négative, on passe à l'étape 79 d'initialisation des ressources $H_{NLD}$= 0 en vue du passage à la phase 3 de calcul des non-linéarités.
Lors de l'étape 80, on calcule la fréquence d'apparition H(2) du code 2, $H_{NLD}(2)$ = H(2).
Au cours de l'étape 81, on initialise à nouveau toutes les ressources $H_{NLD}$ = 0.
Au cours de l'étape 82, on calcule la fréquence d'apparition H(3) du code 3, $H_{NLD}(3)$ = H(3),
**[0126]** Au cours de l'étape 83, on initialise à nouveau l'ensemble des ressources en vue du calcul de la fréquence d'apparition du code i, puis on recommence ces opérations jusqu'au calcul au cours de l'étape 84 de la fréquence d'apparition $H(2^n-1)$ du code $2^n$-1. $H_{NLD}(2^n-1) = H(2^n-1)$.

Au cours de l'étape 85, on initialise toutes les ressources en vue du calcul des non-linéarités intégrales.

Puis au cours de l'étape 86, on calcule la fréquence d'apparition H(2) du code 2.

Au cours de l'étape 87, on procède à l'accumulation avec la valeur précédente $H_{NLI} = H_{NLI} + H(2)$.

Au cours de l'étape 88, on calcule la fréquence d'apparition H(3) du code 3.

Au cours de l'étape 89, on procède à l'accumulation avec la valeur précédente $H_{NLI} = H_{NLI} + H(3)$ et ainsi de suite jusqu'au calcul du cours de l'étape 90 de la fréquence d'apparition $H(2^n-1)$ du code $2^n-1$.

Au cours de l'étape 91, on procède à l'accumulation avec la valeur précédente et on aboutit à l'obtention de la non-linéarité intégrale $H_{NLI} = H_{NLI} +(2^n-1)$.

Enfin, à l'étape 92, on initialise l'ensemble des ressources en vue de la série de calculs suivante.

On donne ci-après un exemple pratique de réalisation d'un convertisseur analogique-numérique à module d'auto-test implanté.

- convertisseur analogique-numérique 8 bits (256 codes),
- fréquence d'échantillonnage 10 Mhz
- fréquence du signal d'entrée 1,22 Mhz
- 8192 échantillons par trame de test. Donc 1000 périodes du signal d'entrée pour chaque trame,
- erreur de décalage admise ± 1,5 LSB
- erreur de gain admise ± 1,5 LSB,
- non-linéarités différentielles admises ± 0,5 LSB,
- non-linéarités intégrales admises ± 0,5 LSB.

Les ressources matérielles nécessaires à la mise en oeuvre de l'invention sont représentées à la figure 2.

Elles comportent

- un bloc de détection de la présence d'un code à la sortie du convertisseur analogique-numérique.

Ce bloc représenté en 10 à la figure 2, est comme indiqué plus haut, un compteur comparateur pour positionner le code de référence.

- un bloc 36 d'exploitation d'histogramme, il est réalisé sous la forme d'un compteur-décompteur à complément à 1,
- un bloc 20 de gestion des trois phases de test ou contrôleur.

Les deux blocs 36 et 10 peuvent être regroupés dans un même bloc.

L'implantation de cette technique est décrite en référence aux figures 3 et 4. Elle est avantageusement réalisée en technologie AMSO,8µm.

On va maintenant détailler la construction et le fonctionnement de chaque bloc.

Le bloc compteur-comparateur 10 permet de positionner dans le compteur le code de référence que l'on désire traiter et de le comparer avec le code de sortie du convertisseur.

Il est constitué de 8 bascules 46a à 46h avec mise à un et mise à zéro reliées par de la logique combinatoire décrite en référence à la figure 3.

Ce bloc a deux fonctions : placer le code de référence et le comparer avec le code de sortie du convertisseur.

La mise en place du code de référence est réalisée en incrémentant la sortie du bloc fonctionnant en mode compteur et la comparaison en mode comparateur s'effectue en réutilisant les portes OU-EXCLUSIF 47a à 47h du compteur.

L'entrée de commande 12 est nécessaire pour passer d'un mode à l'autre.

Si l'entrée de commande 12 reçoit un signal crt = 0, le bloc est placé en mode compteur et la sortie est incrémentée à chaque front d'horloge.

Si l'entrée de commande 12 reçoit un signal ctr = 1, le bloc effectue la comparaison entre le code de référence, out<7:0> et le code de sortie du convertisseur $I_1$<7:0>.

Si les deux codes sont égaux, Ini-A passe à zéro.

Si les deux codes sont différents, Ini-A passe à un.

Le bloc de traitement représenté à la figure 4 permet d'effectuer toutes les opérations nécessaires à l'exploitation de l'histogramme. Comme représenté à la figure 4, il est constitué de sept bascules 53a à 53f et 63 avec mise à zéro et d'une logique combinatoire entre ces différentes bascules.

La sortie 41 est une sortie de huit bits qui représente les différentes caractéristiques.

La sortie 43 est la sortie de la dernière bascule 53g et forme une entrée du contrôleur.

Pour calculer le décalage, le bloc de traitement doit effectuer la soustraction entre la fréquence d'apparition des deux codes extrêmes et doit stocker le résultat.

Cette opération est réalisée en configurant le bloc de traitement en compteur-décompteur à 7 bits. Pour le calcul des autres caractéristiques, le bloc de traitement n'a qu'une fonction d'accumulateur et reste donc en configuration de compteur.

Le résultat contenu dans le bloc de traitement représente la différence entre la valeur théorique et la valeur réelle de la fréquence d'apparition H(i) - $H_{thé}$.

Pour pouvoir exploiter le résultat, il faut tenir compte du signe de cette différence.

Si la valeur stockée dans le bloc 36 est négative, la sortie est complémentée à 1.

Les deux entrées de contrôle C1, C2, 34,35, sont utilisées pour configurer le bloc de traitement.

Il y a quatre modes de fonctionnement :

1) Mode transparence : la sorite S est égale à la sortie des bascules 53a-53f (C1 = C2 = 1).
2) Mode complément : la sortie S est égale au complément à 1 de la sortie des bascules (C1=C2=0).
3) Mode compteur : la sortie est incrémentée à chaque front d'horloge (C1 = 1; C2 = 0).
4) Mode décompteur : la sortie est décrémentée à chaque front d'horloge (C1 = 0; C2 = 1).

Le contrôleur 20 permet de gérer l'ensemble des phases de test.

Les entrées reçoivent les signaux suivants :

- Ini-A 22 donne le résultat de la comparaison entre le code de sortie du CAN et le code de référence.
- InO 23 reçoit le bit de poids faible du code de sortie du convertisseur.
- L'entrée 28 est l'entrée du signal d'horloge ck du contrôleur.
- Les entrées 17a, 17b, 17c, reçoivent outB2, outB6 et outB8, qui sont respectivement les bits 3,7 et le report du bloc compteur-comparateur 10.

Les entrées outA5 et outA7 40 représentent les bits de report 0 et 1 de la sortie 41 du bloc de traitement 36.

Les entrées 30,31 de début et fin sont reliées à un générateur de stimuli (non représenté) et indiquent quand les codes de sortie du convertisseur sont exploitables. L'entrée d'effacement ou clear permet l'initialisation du contrôleur.

Les sorties 32,33 et 37 délivrent des bits de contrôle C1, C2 et clr-A vers le bloc de traitement 36.

La sortie 25 est connectée à l'horloge du bloc compteur-comparateur 10 pour lui délivrer un signal code-suivant.

Les sorties 24,26,27 délivrent des bits de contrôle ctr, clr-B et set-B au compteur-comparateur 10.

Le fonctionnement général du comparateur est détaillé dans l'algorithme représenté à la figure 8.

Durant toutes les phases de test décrites ci-dessous, on considère que le générateur de stimuli fournit deux signaux binaires Début et Fin en plus du signal triangulaire.

Ces signaux désignent le début et la fin de chaque trame de test.

Le nombre de périodes P du signal d'entrée comprises dans la trame dépend de la fréquence du signal d'entrée $f_{in}$, de la fréquence d'échantillonnage $f_e$ et du nombre d'échantillon à traiter N.

$$P = \frac{fe*N}{fin}$$

Il est nécessaire de gérer autant de trames que de codes à traiter durant les différentes phases.

1) Phases de détermination du décalage.

Dans cette phase dont l'algorithme de calcul est représenté à la figure 9, le compteur du compteur-comparateur 10 ne doit avoir en sortie que deux valeurs 00.....00 ou 11.....11.

Par conséquent, le contrôleur ne commande que l'entrée de mise à zéro et à un du compteur.

Le bloc de traitement 36 est configuré en décompteur si le code de sortie est le code 00000000 et en compteur, si le code de sortie est 11111111.

De ce fait, le bloc 36 effectue la soustraction entre les fréquences d'apparition des deux codes extrêmes.

Cette différence est proportionnelle au décalage comme on peut le voir d'après l'équation (1).

Durant cette phase, le traitement des deux codes extrêmes s'effectue simultanément et ne nécessite donc qu'une trame de test.

On voit sur l'algorithme de calcul de la figure 9 que les bits C1, C2, cirA, clr-B, set-B, code-sui et ctr, ont respectivement les valeurs 100010 et 1.

L'initialisation de l'ensemble des blocs est assurée par :

- la mise à zéro du bloc de traitement 36(clr-A=0)
- mise à zéro du compteur-comparateur 10 B(clr-B = 0).

Les bits précités passent alors aux états suivants :

| C1 | C2 | clr-A | clr-B | set-B | code-sui | ctr |
|---|---|---|---|---|---|---|
| 0 | 0 | 1 | 1 | 1 | 0 | 1 |

Le contrôleur attend alors le signal (début) provenant du générateur de stimuli pour commencer le calcul du décalage.
Le signal début passe à 1 et le calcul du décalage a lieu. Il se poursuit tant que le signal Fin=0.
Ce calcul est assuré par le positionnement du compteur du compteur-comparateur 10 au code O ou 1 (clr-B/set-B) suivant que In0 est égal à O ou 1.
Ensuite, il y a comparaison entre ie sortie du compteur et le code de sortie du CAN (In).
Ensuite, il y a incrémentation ou décrémentation du compteur 36 suivant le résultat et la valeur de In0 et le résultat de la comparaison (valeur de Ini-A)
A la fin du calcul du décalage, les bits précités ont les valeurs suivantes :

| | C1 | C2 | clr-A | clr-B | Set-B | Code-sui | ctr |
|---|---|---|---|---|---|---|---|
| Ini-A=0 et Ino=1 | 0 | 1 | 1 | 1 | 0 | 0 | 1 |
| Ini-A=0 et Ino=0 | 1 | 0 | 1 | 0 | 1 | 0 | 1 |
| Ini-A = 1 | 0 | 0 | 1 | 1 | 1 | 0 | 1 |

Le résultat est lu dans le bloc de traitement ou compteur-décompteur 36 et l'on prend ou non le complément du résultat suivant la valeur de report 0.
Les bits précités sont alors les valeurs respectives suivantes :

| | C1 | C2 | clr-A | clr-B | Set-B | Code-sui | ctr |
|---|---|---|---|---|---|---|---|
| outA7=0 | 0 | 0 | 1 | 0 | 1 | 0 | 1 |
| outA7=1 | 1 | 1 | 1 | 0 | 1 | 0 | 1 |

2) Phase de détermination du gain

La phase de détermination du gain va être décrite en référence à l'algorithme de calcul du gain représenté à la figure 10.
Le gain est calculé à l'aide des codes milieux. Il faut traiter un nombre de codes assez important pour obtenir une bonne précision de mesure.
A cet effet, on cumule par exemple la fréquence d'apparition de 61 codes répartis entre le troisième et le soixante quatrième.
On commencera par placer la premier code de référence dans le compteur du compteur-comparateur 10 (code 00000100).
On calcule la fréquence d'apparition de ce code.
Ensuite, le compteur est incrémenté (code 00000101) et la valeur de la fréquence d'apparition est ajoutée à la précédente.
Cette opération est répétée jusqu'au dernier code à traiter (code 01000000). Le résultat peut alors être extrait du bloc de traitement 36.
Pour chaque code, le générateur doit fournir une trame de test complète.
Pour l'exemple traité ici, la mesure du gain nécessite 61 trames.
Les opérations sont les suivantes.
Lors de l'initialisation, les bits C1,C2,clr-A, clr-B, set-B, code-sui, crt, ont initialement les valeurs respectives 0001100.
On initialise alors le compteur-décompteur 36 et le compteur-comparateur 10.
Puis les bits précités passent aux valeurs respectives suivantes :

| C1 | C2 | clr-A | clr-B | Set-B | Code-sui | ctr |
|---|---|---|---|---|---|---|
| 0 | 0 | 1 | 1 | 1 | 1 | 0 |

Il y a mise en place du code de référence sur le compteur du compteur-comparateur 10, puis incrémentation de ce compteur jusqu'au code 00000100 = premier code traité pour déterminer le gain, incrémentation tant que outB2=0.

Lorsque outB2=1, les bits précités prennent les valeurs 0011110.

Le système est en attente : le contrôleur 20 attend le signal (début) provenant du générateur de stimuli pour commencer le calcul du gain.

Le signal début passe à Début = 1.

Les bits précités passent alors aux valeurs suivantes :

| | C1 | C2 | clr-A | clr-B | Set-B | Code-sui | ctr |
|---|---|---|---|---|---|---|---|
| IniA=0 | 1 | 0 | 1 | 1 | 1 | 0 | 1 |
| IniA=1 | 0 | 0 | 1 | 1 | 1 | 1 | 0 |

Il y a calcul du gain tant que le signal Fin=0.

Il y a comparaison entre ia sortie du compteur du compteur-comparateur 10 et le code de sortie du CAN (In).

Suivant le résultat de cette comparaison, il y a incrémentation du compteur-décompteur 36.

Les bits précités passent alors aux valeurs suivantes 0011100.

On incrémente alors de compteur du compteur-comparateur 10 si le code de référence n'est pas égal au dernier code à traiter (01000000) pour déterminer le gain et on recommence sans initialiser le compteur-décompteur.

Lorsque le signal outB6=1, les bits précités passent aux valeurs suivantes :

| | C1 | C2 | clr-A | clr-B | Set-B | Code-sui | ctr |
|---|---|---|---|---|---|---|---|
| outA5=0 | 0 0 | | | | 1 | 0 | 0 |
| outA5=1 | 1 | 1 | 1 | 0 | 1 | 0 | 0 |

On lit le résultat dans le bloc de traitement 36 et on prend ou non le complément du résultat suivant la valeur de outA5.

On va maintenant décrire la phase de détermination des non-linéarités.

3) Phase de détermination des non-linéarités,

On commence par les non-linéarités différentielles. La phase de détermination des non-linéarités différentielles va être décrite en référence à l'algorithme de calcul des NLD représenté figure 11.

Le premier code à traiter est positionné à la sortie du compteur-comparateur 10.

La fréquence d'apparition de ce code est calculée dans le compteur-décompteur 36. Ensuite, le compteur-décompteur 36 est initialisé et on incrémente le compteur du compteur-comparateur 10 pour placer le code suivant et ainsi de suite.

Une trame complète (Ppériodes) du signal d'entrée est nécessaire pour chaque code (traitement séquentiel).

Lors de l'initialisation, les bits C1,C2,clr-A, clr-B, set-B, code-sui, ctr, ont respectivement les valeurs suivantes : 0000100.

Il y a initialisation des circuits 36 et 10.

Puis, les bits précités passent aux valeurs suivantes 0011110. Le contrôleur 20 attend le signal "début" provenant du générateur de stimuli (non représenté) pour commencer le calcul des non-linéarités.

Lorsque les signaux début=1 et outB8=0, les bits précités prennent les valeurs suivantes :

| | C1 | C2 | clr-A | clr-B | Set-B | Code-sui | ctr |
|---|---|---|---|---|---|---|---|
| IniA=0 | 1 | 0 | 1 | 1 | 1 | 0 | 1 |
| IniA=1 | 0 | 0 | 1 | 1 | 1 | 0 | 1 |

Tant que Fin=0, il y a calcul des non-linéarités. Il y a comparaison entre la sortie du circuit 10 et le code de sortie du CAN(In), puis incrémentation ou non du circuit 36 suivant le résultat.

Lorsque Fin=1, les bits précités passent ensuite aux valeurs suivantes:

| | C1 | C2 | clr-A | clr-B | Set-B | Code-sui | ctr |
|---|---|---|---|---|---|---|---|
| outA5=0 | 0 | 0 | 1 | 1 | 1 | 0 | 0 |
| outA5=1 | 1 | 1 | 1 | 1 | 1 | 0 | 0 |

Puis, il y a lecture du résultat dans le circuit 36 et complémentation ou pas de ce résultat suivant la valeur de outA5.

Enfin, les bits précités prennent les valeurs suivantes 0001100.

On incrémente alors le compteur du compteur-comparateur 10 et on initialise le circuit compteur-décompteur 36 (ctr-A=0).

Les non-linéarités intégrales NLI sont déterminées comme suit en référence à l'algorithme de calcul représenté figure 12.

La même opération que pour la détermination des non-linéarités différentielles est répétée, mais sans initialiser le compteur-décompteur 36 avant chaque trame.

On voit sur l'algorithme de la figure 12 qu'à l'initialisation du dispositif, les bits précités ont les valeurs suivantes : 0000100.

Il y a initialisation des blocs 36 et 10 (Fig.2).

Ensuite, ces bits passent respectivement aux valeurs suivantes 0011110.

Le contrôleur 20 attend le signal "début" provenant du générateur de stimuli pour commencer le calcul des non-linéarités.

Si outB8=1, les bits précités passent aux valeurs :
0000100. On initialise les blocs 36 et 10.

Si outB8=0, le contrôleur 20 attend le signal "début" provenant du générateur de stimuli pour commencer le calcul des non-linéarités intégrales.

A l'apparition des signaux de Début= 1 et outB8=0, les bits précités prennent les valeurs suivantes:

| | C1 | C2 | clr-A | clr-B | Set-B | Code-sui | ctr |
|---|---|---|---|---|---|---|---|
| In1A=0 | 0 | 1 | 1 | 1 | 1 | 0 | 1 |
| IniA=1 | 0 | 0 | 1 | 1 | 1 | 1 | 0 |

Le calcul des non-linéarités intégrales a lieu tant que Fin=0.

Lorsque Fin=1, on compare la sortie du circuit 10 avec le code de sortie du CAN (In) et on incrémente ou non le circuit 36 suivant le résultat.

Les bits précités ont alors les valeurs suivantes :

| | C1 | C2 | clr-A | clr-B | Set-B | -Code-sui | -ctr |
|---|---|---|---|---|---|---|---|
| outA7=0 | 0 | 0 | 1 | 1 | 1 | 0 | 0 |
| outA7=1 | 1 | 1 | 1 | 1 | 1 | 0 | 0 |

On lit alors le résultat dans le bloc de traitement ou compteur-décompteur 36 et on le complémente ou non suivant la valeur de outA5.

Les bits passent aux valeurs : 0011100.

Enfin, on incrémente le compteur du compteur-comparateur 10.

## Revendications

1. Procédé de test par histogramme d'un convertisseur analogique-numérique, consistant à décomposer dans le temps, l'accumulation et l'exploitation de l'histogramme, **caractérisé en ce qu'**il fait appel à des ressources communes pour traiter successivement les caractéristiques fonctionnelles du convertisseur analogique-numérique et **en ce qu'**il consiste à initialiser et configurer successivement lesdites ressources en vue de les adapter à la détermination de chacune des caractéristiques fonctionnelles dudit convertisseur.

**2.** Procédé suivant la revendication 1, **caractérisé en ce que**, à un instant donné, du traitement d'une caractéristique fonctionnelle, les ressources communes ne concernent qu'un code ou qu'un groupe de codes traités simultanément.

**3.** Procédé suivant la revendication 1 ou 2, **caractérisé en ce que** lesdites caractéristiques fonctionnelles du convertisseur sont le décalage, le gain et les non-linéarités.

**4.** Procédé suivant la revendication 3, **caractérisé en ce que** la détermination du décalage est assurée par échantillonnage d'un signal triangulaire appliqué au convertisseur et par calcul à partir de deux codes extrêmes résultant de l'échantillonnage dudit signal triangulaire qui sont les seuls codes modifiés dans le cas d'une erreur de décalage, à l'aide de la relation .

$$\text{Décalage} = \frac{(H(2^n)-H(1)).A.Te.2^n}{Tin.PE} + C$$

dans laquelle :

A est l'amplitude du signal d'entrée,
C est une constante connue tenant compte du décalage de la caractéristique idéale,
Te est la période d'échantillonnage,
Tin est la période du signal d'entrée,
$H(2^n)$ est le nombre d'échantillons pour le code 111...11,
H(1) est le nombre d'échantillon pour le code 000...00,
PE est la pleine échelle du convertisseur.

**5.** Procédé suivant l'une des revendications 3 et 4, **caractérisé en ce que** la détermination du gain est assurée par échantillonnage d'un signal triangulaire appliqué au convertisseur et formation de codes successifs comprenant chacun un nombre d'échantillons dudit signal et définissant un pas de quantification qr et calcul de l'erreur de gain à l'aide de la relation:

$$\text{Erreur de gain} = \frac{qr\text{-q}}{q} = \frac{Ncode.2^{n-1}.A.Te\text{-}PE.Tin}{.PE.Tin}$$

dans laquelle A, Te, Tin et PE représentent respectivement l'amplitude du signal d'entrée, la période d'échantillonnage, la période du signal d'entrée et la tension de référence du convertisseur.

**6.** Procédé suivant l'une des revendications 3 à 5, **caractérisé en ce que** les non-linéarités sont des non-linéarités différentielles et des non-linéarités intégrales.

**7.** Procédé suivant l'une des revendications 3 à 6, **caractérisé en ce que** la détermination des non-linéarités différentielles représentant la différence par rapport au bit le moins significatif LSB des valeurs analogiques correspondant à deux codes successifs, est assurée à l'aide de la relation :

$$\text{NLD (i)} = \frac{H(i) - H_{thé}}{H_{thé}}$$

avec $H_{thé} = \frac{N}{2^n}$
H(i) étant la fréquence d'apparition de chaque code i à la sortie du convertisseur analogique-numérique,

**8.** Procédé suivant l'une des revendications 3 à 7, **caractérisé en ce que** la détermination des non-linéarités intégrales représentant l'écart par rapport au bit de poids le plus faible LSB entre la caractéristique réelle et la droite idéale, est assurée par la relation suivante :

$$NLI(i) = \sum_{j=1}^{i} NND(j)$$

les non-linéarités intégrales étant calculées par accumulation des non-linéarités différentielles.

**9.** Dispositif d'auto-test d'un convertisseur analogique-numérique pour la mise en oeuvre du procédé, suivant l'une des revendications 1 à 8, comprenant des moyens (2,5) d'application au convertisseur de signaux de test, et des moyens d'analyse (6), **caractérisé en ce que** lesdits moyens d'analyse comportent des ressources communes intégrées et configurables pour traiter successivement des caractéristiques fonctionnelles du convertisseur et des moyens (20) de configuration desdites ressources communes en vue de les adapter aux caractéristiques à traiter.

**10.** Dispositif suivant la revendication 9, **caractérisé en ce que** les moyens d'analyse sont intégrés sur le même silicium que le convertisseur analogique-numérique.

**11.** Dispositif suivant la revendication 9 ou 10, **caractérisé en ce que** lesdits moyens d'analyse comportent un compteur d'un code de référence - comparateur (10) connecté à la sortie du convertisseur analogique-numérique, un compteur/décompteur (36) d'exploitation et de stockage dont la sortie délivre des signaux relatifs aux caractéristiques fonctionnelles du convertisseur et un contrôleur (20) de gestion des phases de test au moyen dudit compteur-comparateur (10) et dudit compteur-décompteur (36).

**12.** Dispositif suivant la revendication 11, **caractérisé en ce que** ledit compteur de code de référence-comparateur (10) et le compteur-décompteur (36) sont réunis dans un même bloc.

**13.** Dispositif suivant la revendication 11, **caractérisé en ce que** ledit compteur-comparateur (10) comprend un compteur à huit bits dont chacun des étages comporte un ensemble de portes (45a à 45h) auquel est associée une bascule (46a à 46h) et un comparateur comprenant pour chaque étage, une porte NON-OU EXCLUSIF (47a à 47h) dont une entrée est reliée à une entrée (11) de réception des signaux de sortie du convertisseur analogique-numérique par l'intermédiaire d'un multiplexeur (48a à 48h) dont une autre entrée est reliée par l'intermédiaire d'une porte NON-ET (49a à 49h) à la borne Q de la bascule (46b) de l'étage suivant.

**14.** Dispositif suivant l'une des revendications 9 à 11, **caractérisé en ce que** le compteur-décompteur (36) comporte des groupes de portes (52a à 52f) auxquelles sont associées des bascules correspondantes (53a à 53g) et des entrées (34,35) pour des signaux (C1,C2) de configuration du compteur-décompteur (36) en compteur ou en décompteur par ledit contrôleur (20) de gestion des phases de test.

**15.** Convertisseur analogique-numérique, **caractérisé en ce qu'**il comporte un dispositif de test intégré suivant l'une des revendications 9 à 14.

## Patentansprüche

**1.** Verfahren zum Testen eines Analog/Digital-Wandlers durch Histogramm, das darin besteht, daß die Akkumulation und die Auswertung des Histogramms in der Zeit zerlegt wird, **dadurch gekennzeichnet, daß** es gemeinsame Ressourcen benutzt, um nacheinander die Betriebscharakteristiken des Analog/Digital-Wandlers zu bearbeiten, und daß es darin besteht, daß diese Ressourcen nacheinander initialisiert und konfiguriert werden, um sie an die Bestimmung jeder der Betriebscharakteristiken dieses Wandlers anzupassen.

**2.** Verfahren nach Anspruch 1, **dadurch gekennzeichnet, daß** zu einem gegebenen Zeitpunkt der Behandlung einer Betriebscharakteristik die gemeinsamen Ressourcen nur einen Code oder eine Gruppe von gleichzeitig verarbeiteten Codes betreffen.

**3.** Verfahren nach Anspruch 1 oder 2, **dadurch gekennzeichnet, daß** diese Betriebscharakteristiken des Wandlers die Verschiebung, die Verstärkung und die Nichtlinearitäten sind.

**4.** Verfahren nach Anspruch 3, **dadurch gekennzeichnet, daß** die Bestimmung der Verschiebung *durch* Abtastung eines an den Wandler angelegten dreieckigen Signals und durch Berechnung ausgehend von zwei sich aus der Abtastung dieses dreieckigen Signals ergebenden extremen Codes gewährleistet wird, die die einzigen im Fall einer Verschiebungsabweichung geänderten Codes sind, und zwar mit Hilfe der Beziehung:

$$\text{Verschiebung} = \frac{(H(2^n)\text{-}H(1)).A.Te.2^n}{Tin.PE} + \text{C}$$

in der:

A die Amplitude des Eingangssignals ist,
C eine bekannte Konstante ist, die die Verschiebung der idealen Charakteristik berücksichtigt,
Te die Abtastperiode ist,
Tin die Periode des Eingangssignals ist,
$H(2^n)$ die Anzahl Abtastungen bei dem Code 111...11 ist,
H(1) die Abtastungszahl bei dem Code 000...00 ist,
PE der volle Umfang des Wandlers ist.

5. Verfahren nach einem der Ansprüche 3 und 4, **dadurch gekennzeichnet, daß** die Bestimmung der Verstärkung durch Abtastung eines an den Wandler angelegten dreieckigen Signals und Bildung von aufeinanderfolgenden Codes, die jeweils eine Anzahl Abtastungen dieses Signals umfassen und einen Quantifizierungsschritt qr definieren, und Berechnung der Verstärkung mit Hilfe der Beziehung gewährleistet wird:

$$\text{Verstärkungsabweichung} = \frac{qr\text{-q}}{q} = \frac{Ncode.2^{n-1}.A.Te\text{-}PE.Tin}{.PE.Tin}$$

in der A, Te, Tin und PE die Amplitude des Eingangssignals, die Abtastperiode, die Periode des Eingangssignals bzw. die Bezugsspannung des Wandlers darstellen.

6. Verfahren nach einem der Ansprüche 3 bis 5, **dadurch gekennzeichnet, daß** die Nichtlinearitäten Differenz-Nichtlinearitäten und Integral-Nichtlinearitäten sind.

7. Verfahren nach einem der Ansprüche 3 bis 6, **dadurch gekennzeichnet, daß** die Bestimmung der Differenz-Nichtlinearitäten, die die Differenz der den beiden aufeinanderfolgenden Codes entsprechenden analogen Werten bezüglich des am wenigsten signifikanten Bits LSB darstellen, mit Hilfe der Gleichung gewährleistet wird:

$$\text{NLD (i)} = \frac{H(i) - H_{the}}{H_{the}}$$

mit $H_{the} = \frac{N}{2^n}$
wobei H(i) die Frequenz des Auftretens jedes Codes i am Ausgang des Analog/Digital-Wandlers ist.

8. Verfahren nach einem der Ansprüche 3 bis 7, **dadurch gekennzeichnet, daß** die Bestimmung der Integral-Nichtlinearitaten, die die Abweichung zwischen der tatsächlichen Charakteristik und der idealen Geraden bezüglich des Bits LSB mit dem kleinsten Gewicht darstellen, durch die folgende Beziehung gewährleistet wird:

$$\text{NLI}(i) = \sum_{j=1}^{i} NND(j)$$

wobei die Integral-Nichtlinearitäten durch Akkumulation der Differenz-Nichtlinearitäten errechnet werden.

9. Vorrichtung zum Selbsttest eines Analog/Digital-Wandlers für die Durchführung des Verfahrens nach einem der Ansprüche 1 bis 8, umfassend Mittel (2, 5) zum Anlegen von Testsignalen an den Wandler und Analysemittel (6), **dadurch gekennzeichnet, daß** die Analysemittel gemeinsame Ressourcen, die integriert und konfigurierbar sind, um nacheinander Betriebscharakteristiken des Wandlers zu bearbeiten, und Mittel (20) zum Konfigurieren dieser gemeinsamen Ressourcen umfassen, um sie an die zu behandelnden Charakteristiken anzupassen.

**10.** Vorrichtung nach Anspruch 9, **dadurch gekennzeichnet, daß** die Analysemittel auf demselben Silicium wie der Analog/Digital-Wandler integriert sind.

**11.** Vorrichtung nach Anspruch 9 oder 10, **dadurch gekennzeichnet, daß** die Analysemittel eine Einrichtung zum Zählen eines Bezugscodes und zum Vergleichen (10), die an den Ausgang des Analog/Digital-Wandlers angeschlossen ist, einen Vorwärts-Rückwärts-Zähler (36) zur Auswertung und Speicherung, dessen Ausgang die Betriebscharakteristiken des Wandlers betreffende Signale liefert, und eine Steuerung (20) zur Verwaltung der Testphasen mit Hilfe dieser Einrichtung zum Zählen und Vergleichen (10) und des Vorwärts-Rückwärts-Zählers (36) umfassen.

**12.** Vorrichtung nach Anspruch 11, **dadurch gekennzeichnet, daß** diese Einrichtung zum Zählen eines Bezugscodes und zum Vergleichen (10) und der Vorwärts-Rückwärts-Zähler (36) in einem gemeinsamen Block vereinigt sind.

**13.** Vorrichtung nach Anspruch 11, **dadurch gekennzeichnet, daß** die Einrichtung (10) zum Zählen und Vergleichen einen Zähler zu acht Bit aufweist, von dem jede der Stufen eine Einheit von Gattern (45a bis 45h) umfaßt, der ein Kippkreis (46a bis 46h) zugeordnet ist, sowie einen Vergleicher, der für jede Stufe ein Exklusiv-Nicht-Oder-Gatter (47a bis 47h) aufweist, von dem ein Eingang mit einem Eingang (11) zum Empfang der Ausgangssignale des Analog-Digital-Wandlers über einen Multiplexer (48a bis 48h) verbunden ist, von dem ein anderer Eingang über ein Nicht-Und-Gatter (49a bis 49h) mit der Klemme Q des Kippkreises (46b) der folgenden Stufe verbunden ist.

**14.** Vorrichtung nach einem der Ansprüche 9 bis 11, **dadurch gekennzeichnet, daß** der Vorwärts-Rückwärts-Zähler (36) Gruppen von Gattern (52a bis 52f) aufweist, denen entsprechende Kippkreise (53a bis 53g) und Eingänge (34, 35) für Signale (C1, C2) zum Konfigurieren des Vorwärts-Rückwärts-Zählers (36) als Vorwärtszähler oder als Rückwärtszähler durch die Steuerung (20) zur Verwaltung der Testphasen zugeordnet sind.

**15.** , Analog/Digital-Wandler, **dadurch gekennzeichnet, daß** er eine integrierte Testvorrichtung nach einem der Ansprüche 9 bis 14 aufweist.

## Claims

**1.** Method of histogram testing of an analogue-to-digital converter, comprising breaking down in time the accumulation and the operation of the histogram, **characterised in that** it makes use of common resources in order to process successively the functional characteristics of the analogue-to-digital converter and that it comprises initialising and configuring the said resources successively with a view to adapting them to the determination of each of the functional characteristics of the said converter.

**2.** Method as claimed in Claim 1, **characterised in that** at a given instant in the processing of a functional characteristic the common resources only concern a code or a group of codes processed simultaneously.

**3.** Method as claimed in Claim 1 or 2, **characterised in that** the said functional characteristics of the converter are the shift, the gain and the non-linearities.

**4.** Method as claimed in Claim 3, **characterised in that** the determination of the shift is ensured by sampling of a triangular signal applied to the converter and by calculation from two extreme codes resulting from the sampling of the said triangular signal which are the only codes modified in the case of a shift error, with the aid of the relation

$$\text{shift} = \frac{(H(2^n)-H(1)).A.Te.2^n}{Tin.PE} + C$$

in which:

A is the amplitude of the input signal,
C is a known constant taking account of the shift of the ideal characteristic,

Te is the sampling period,
Tin is the input signal period,
$H(2^n)$ is the number of samples for the code 111....11,
H(1) is the number of samples for the code 000...00,
PE is the full scale of the converter.

**5.** Method as claimed in one of Claims 3 and 4, **characterised in that** the determination of the gain is ensured by sampling of a triangular signal applied to the converter and formation of successive codes each comprising a number of samples of the said signal and defining a quantisation step qr and calculation of the gain error with the aid of the relation:

$$\text{gain error} = \frac{qr\text{-}q}{q} = \frac{Ncode.2^{n\text{-}1}.A.Te\text{-}PE.Tin}{.PE.Tin}$$

in which A, Te, Tin and PE represent respectively the amplitude of the input signal, the sampling period, the period of the input signal and the reference voltage of the converter.

**6.** Method according to one of Claims 3 to 5, **characterised in that** the non-linearities are differential non-linearities and integral non-linearities.

**7.** Method as claimed in one of Claims 3 to 6, **characterised in that** the determination of the differential non-linearities representing the difference relative to the least significant bit LSB of the analogue values corresponding to two successive codes is ensured with the aid of the relation:

$$\text{NLD(i)} = \frac{H(i)\text{ - }H_{the}}{H_{the}}$$

with $H_{the} = \frac{N}{2^n}$
H(i) being the frequency of appearance of each code i at the output of the analogue-to-digital converter.

**8.** Method as claimed in one of Claims 3 to 7, **characterised in that** the determination of the integral non-linearities representing the deviation relative to the least significant bit LSB between the real characteristic and the ideal straight line is ensured by the following relation:

$$\text{NLI(i)} = \sum_{j=1}^{i} NND(j)$$

the integral non-linearities being calculated by accumulation of the differential non-linearities.

**9.** Device for self-testing of an analogue-to-digital converter for carrying out the method as claimed in one of Claims 1 to 8, comprising means (2, 5) for application of test signals to the converter and analysis means (6), **characterised in that** the said analysis means comprise common resources which are integrated and configurable in order to process successively functional characteristics of the converter and means (20) for configuration of the said common resources with a view to adapting them to the characteristics to be processed.

**10.** Device as claimed in Claim 9, **characterised in that** the analysis means are integrated on the same silicon as the analogue-to-digital converter.

**11.** Device as claimed in Claim 9 or 10, **characterised in that** the said analysis means comprise a reference code counter/comparator (10) connected to the output of the analogue-to-digital converter, and up/down counter (36) for operation and storage, the output of which delivers signals relating to the functional characteristics of the converter, and a controller (20) for management of the test phases by means of the said counter/comparator (10) and the said up/down counter (36).

**12.** Device as claimed in Claim 11, **characterised in that** the said reference code counter/comparator (10) and the up/down counter (36) are combined in one and the same unit.

**13.** Device as claimed in Claim 11, **characterised in that** the said counter/comparator (10) comprises an eight-bit counter of which each of the stages has a set of gates (45a to 45h)with which is associated a flipflop (46a to 46h) and a comparator comprising for each stage a NOR gate (47a to 47h) of which an input is connected to an input (11) for reception of the output signals from the analogue-digital converter via a multiplexer (48a to 48h) of which another input is connected via a NAND gate (49a to 49h) to the terminal Q of the flipflop (46b) of the following stage.

**14.** Device as claimed in one of Claims 9 to 11, **characterised in that** the up/down counter (36) comprises groups of gates (52a to 52f) with which are associated corresponding flipflops (53a to 53g) and inputs (34, 35) for signals (C1, C2) for configuration of the up/down counter (36) as an up counter or as a down counter by the said controller (20) for management of the test phases.

**15.** Analogue-to-digital converter, **characterised in that** it comprises an integrated testing device as claimed in one of Claims 9 to 14.

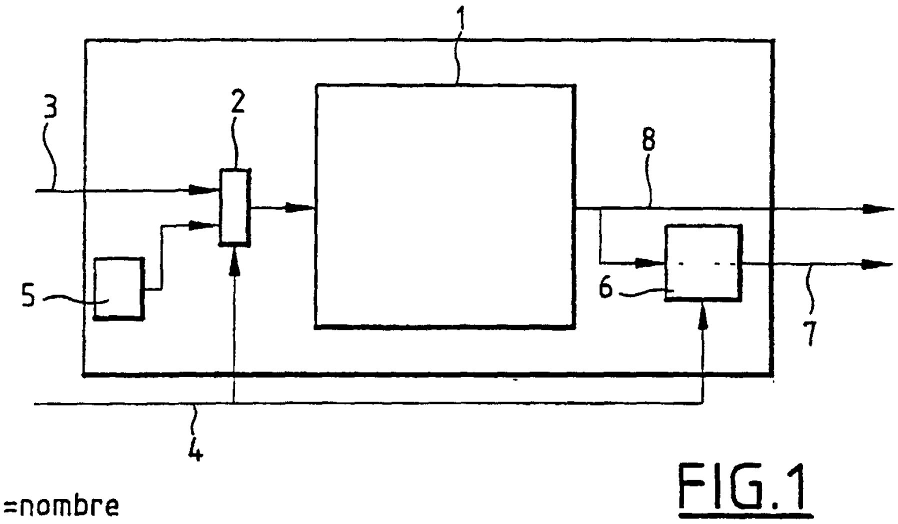


FIG.1

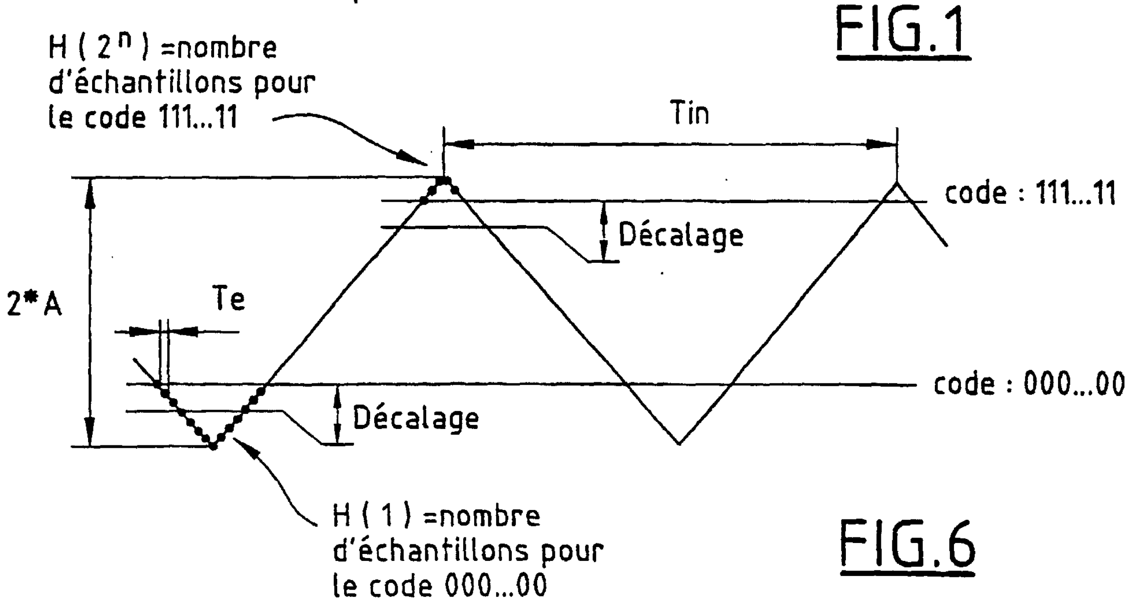


FIG.6

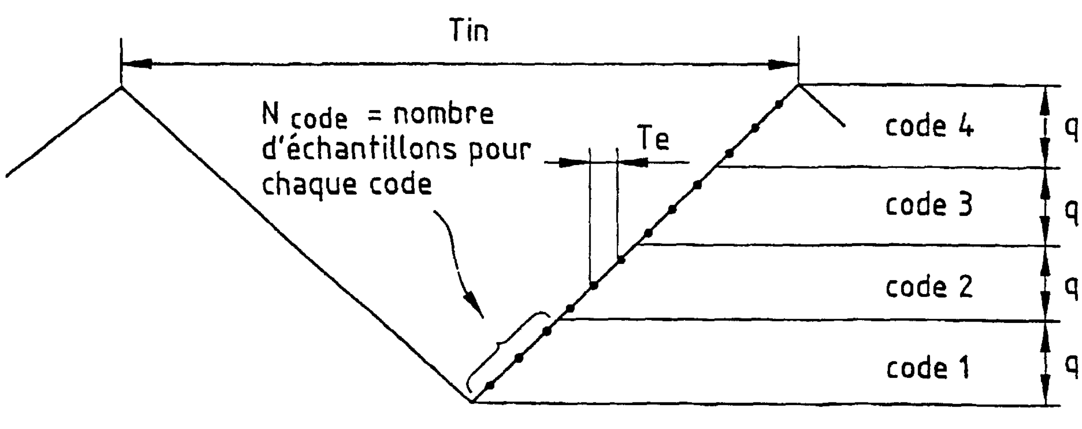


FIG.7

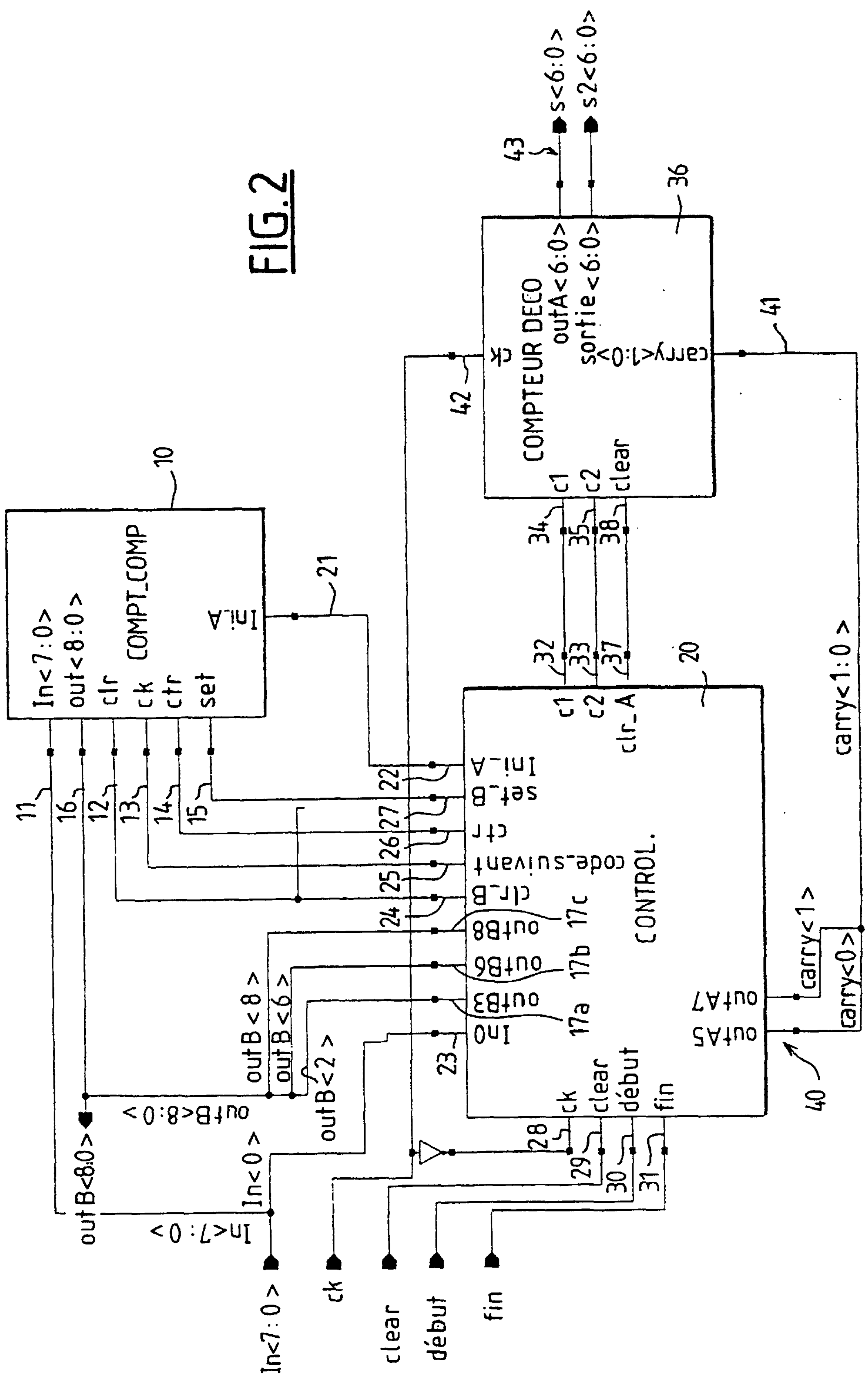
COMPT_COMP
In<7:0>
out<8:0>
clr
ck
ctr
set
Ini_A
CONTROL.
Ini_A
set_B
ctr
code-suivant
clr_B
outB8
outB6
outB3
In0
c1
c2
clr_A
outA7
outA5
ck
clear
début
fin
COMPTEUR DECO
ck
outA<6:0>
sortie<6:0>
carry<1:0>
c1
c2
clear
s<6:0>
s2<6:0>
carry<1:0>
carry<1>
carry<0>
outB<8>
outB<6>
outB<2>
outB<8:0>
In<0>
In<7:0>
ck
clear
début
fin
10
11
12
13
14
15
16
17a
17b
17c
20
21
22
23
24
25
26
27
28
29
30
31
32
33
34
35
36
37
38
40
41
42
43

FIG.2

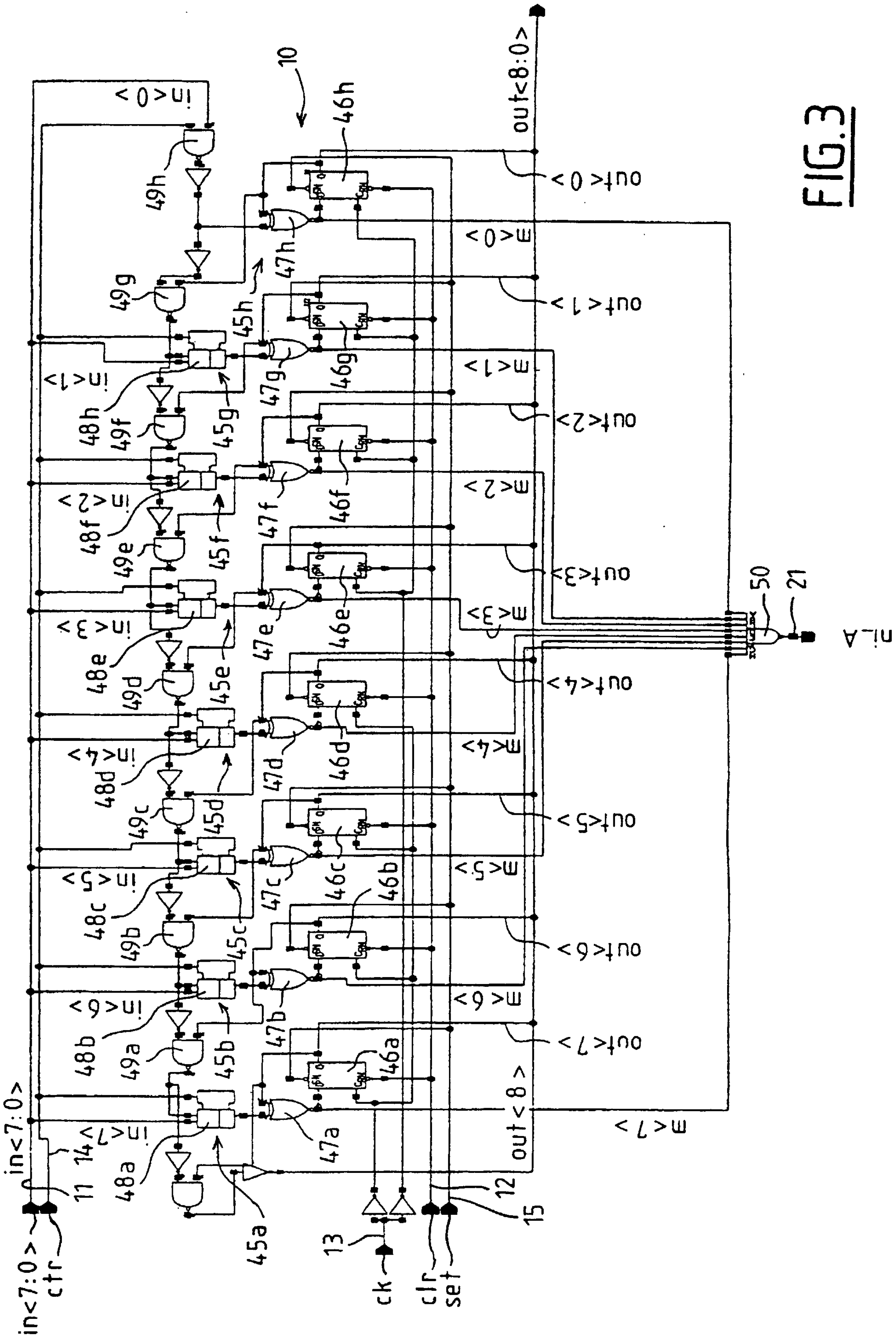
10
out<8:0>
in<7:0>
ctr
ck
clr
set
11
12
13
14
15
21
50
ini_A
in<0>
in<1>
in<2>
in<3>
in<4>
in<5>
in<6>
in<7>
out<0>
out<1>
out<2>
out<3>
out<4>
out<5>
out<6>
out<7>
out<8>
m<0>
m<1>
m<2>
m<3>
m<4>
m<5>
m<6>
m<7>
45a
45b
45c
45d
45e
45f
45g
45h
46a
46b
46c
46d
46e
46f
46g
46h
47a
47b
47c
47d
47e
47f
47g
47h
48a
48b
48c
48d
48e
48f
48h
49a
49b
49c
49d
49e
49f
49g
49h

FIG.3

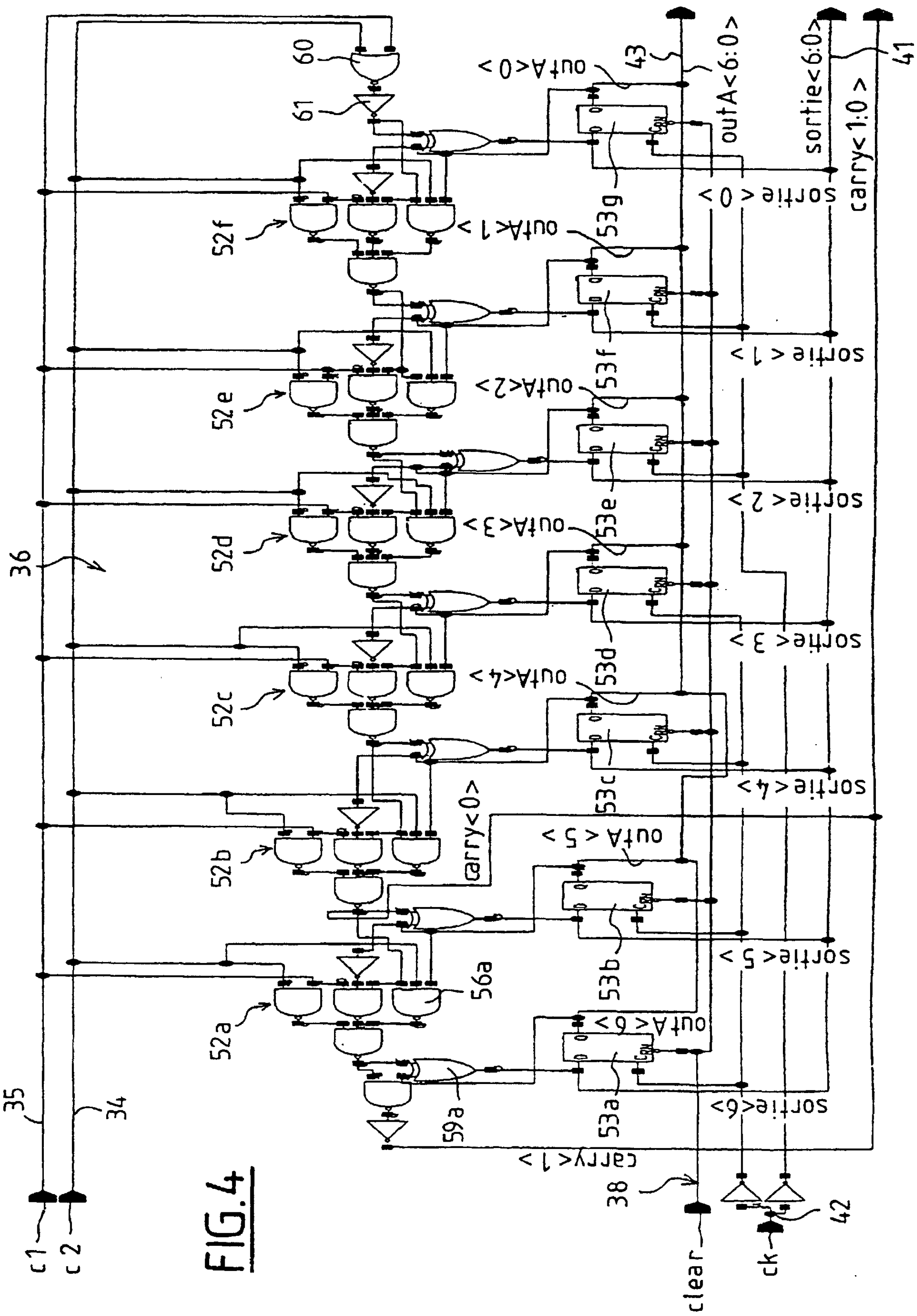
c1
c2
35
34
36
52a
52b
52c
52d
52e
52f
56a
59a
60
61
53a
53b
53c
53d
53e
53f
53g
carry<1>
carry<0>
outA<6>
outA<5>
outA<4>
outA<3>
outA<2>
outA<1>
outA<0>
outA<6:0>
43
sortie<6>
sortie<5>
sortie<4>
sortie<3>
sortie<2>
sortie<1>
sortie<0>
sortie<6:0>
carry<1:0>
41
38
clear
ck
42

FIG.4

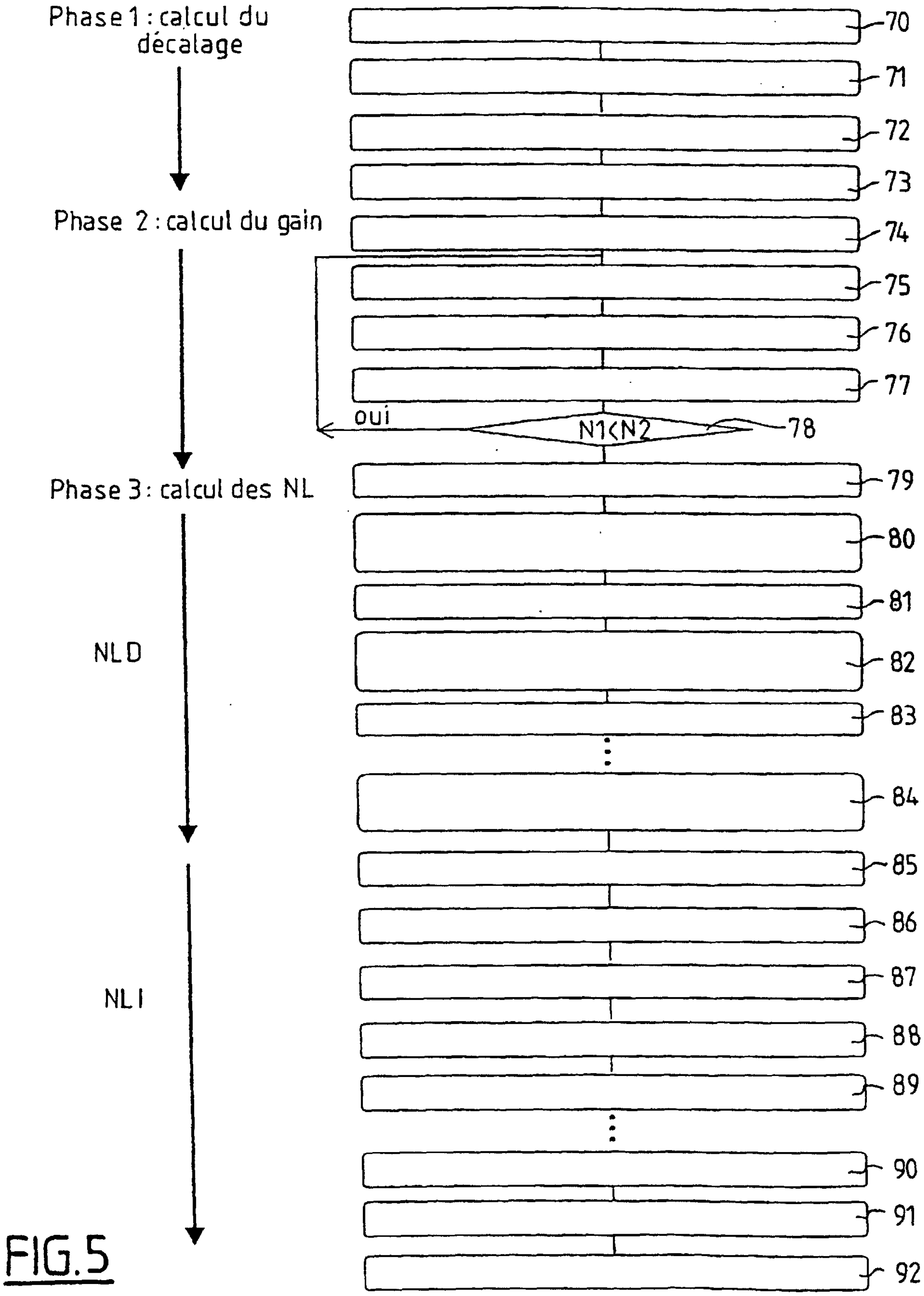
Phase 1 : calcul du décalage
Phase 2 : calcul du gain
Phase 3 : calcul des NL
NLD
NLI
oui
N1<N2
70
71
72
73
74
75
76
77
78
79
80
81
82
83
84
85
86
87
88
89
90
91
92

FIG.5

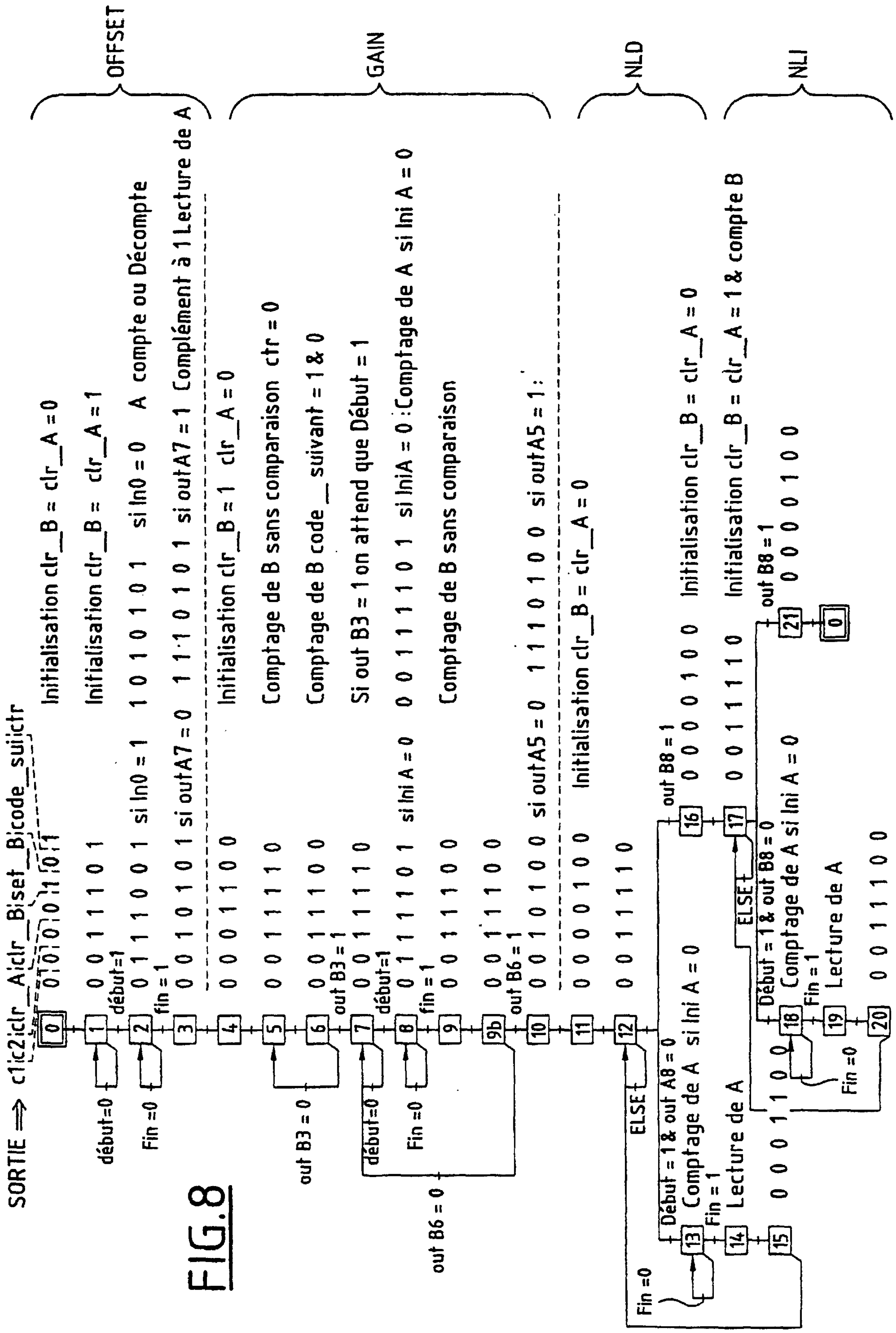
SORTIE ⟹ c1ic2iclr_Aiclr_Biset_Bicode_suiictr
OFFSET
GAIN
NLD
NLI
Initialisation clr_B = clr_A = 0
Initialisation clr_B = clr_A = 1
si In0 = 0 A compte ou Décompte
si outA7 = 1 Complément à 1 Lecture de A
Initialisation clr_B = 1 clr_A = 0
Comptage de B sans comparaison ctr = 0
Comptage de B code suivant = 1 & 0
Si out B3 = 1 on attend que Début = 1
si IniA = 0 : Comptage de A si Ini A = 0
Comptage de B sans comparaison
si outA5 = 1 :
Initialisation clr_B = clr_A = 0
Initialisation clr_B = clr_A = 1 & compte B
Début = 1 & out A8 = 0
Comptage de A si Ini A = 0
Lecture de A
ELSE
Fin = 0
out B3 = 0
out B6 = 0

FIG.8

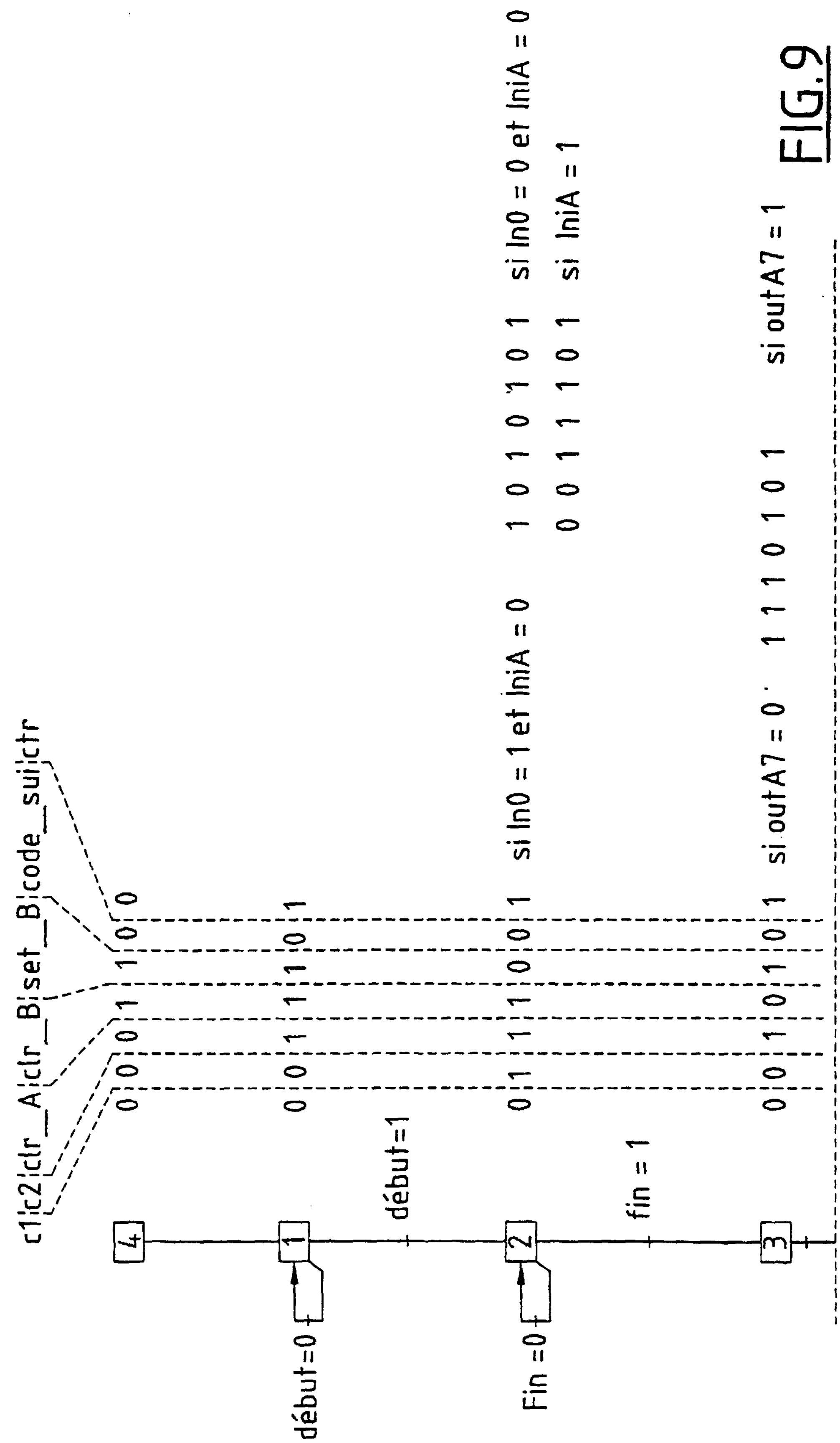
c1¦c2¦clr__A¦clr__B¦set__B¦code__sui¦ctr
4
0 0 0 1 1 0 0
1
0 0 1 1 1 0 1
début=0
début=1
2
0 1 1 1 0 0 1 si In0 = 1 et IniA = 0 1 0 1 0 1 0 1 si In0 = 0 et IniA = 0
0 0 1 1 1 0 1 si IniA = 1
Fin =0
fin = 1
3
0 0 1 0 1 0 1 si outA7 = 0 1 1 1 0 1 0 1 si outA7 = 1

FIG.9

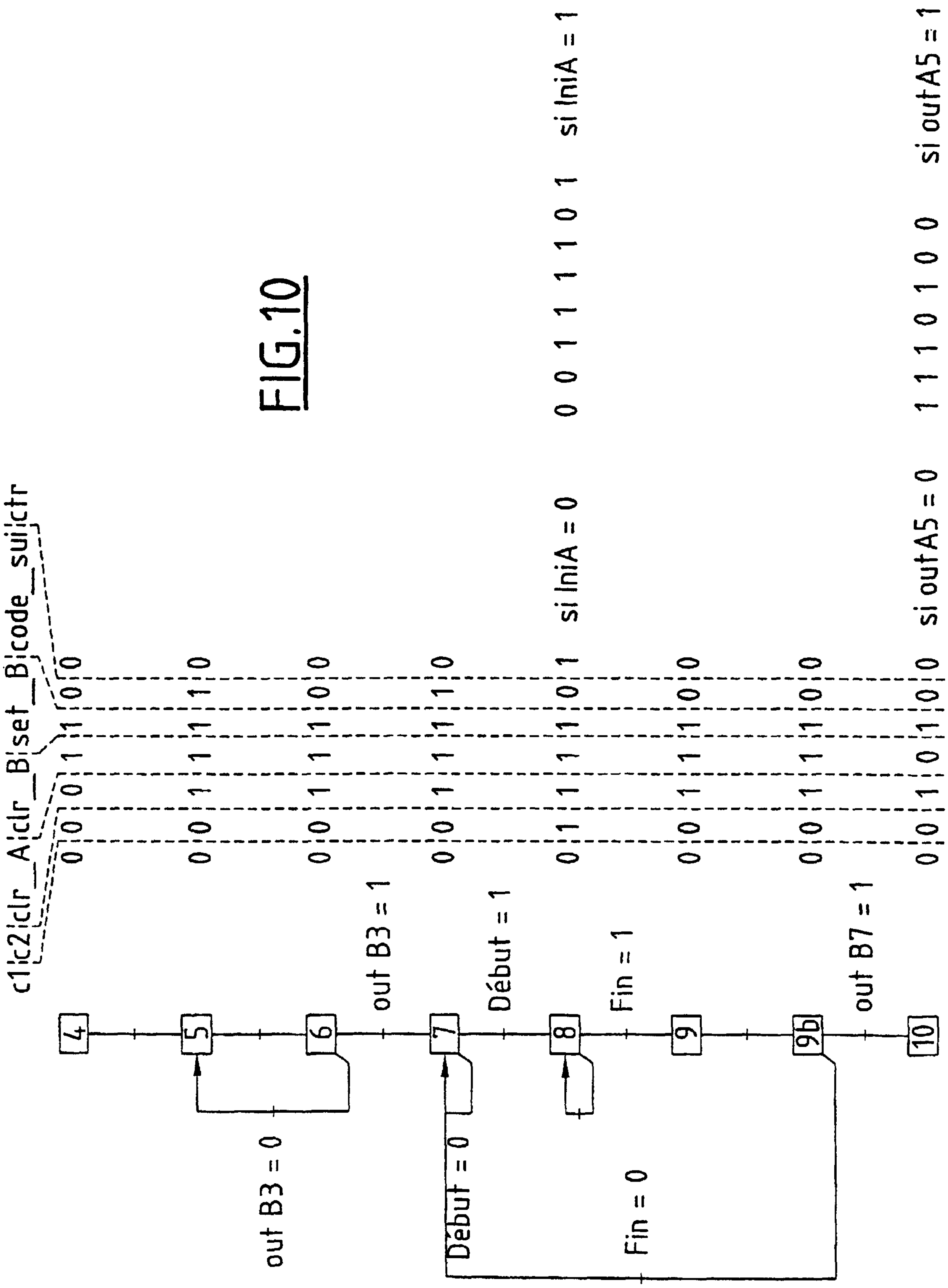

c1lc2lclr
Aiclr
Biset
Bicode
suiictr
0 0 0 0 1 0 0
0 0 1 1 1 1 0
0 0 1 1 1 0 0
0 0 1 1 1 1 0
0 1 1 1 1 0 1
0 0 1 1 1 0 0
0 0 1 1 1 0 0
0 0 1 0 1 0 0
si IniA = 0
si IniA = 1
0 0 1 1 1 1 0 1
si outA5 = 0
si outA5 = 1
1 1 1 0 1 0 0
4
5
6
7
8
9
9b
10
out B3 = 1
Début = 1
Fin = 1
out B7 = 1
out B3 = 0
Début = 0
Fin = 0


FIG.10

FIG.11

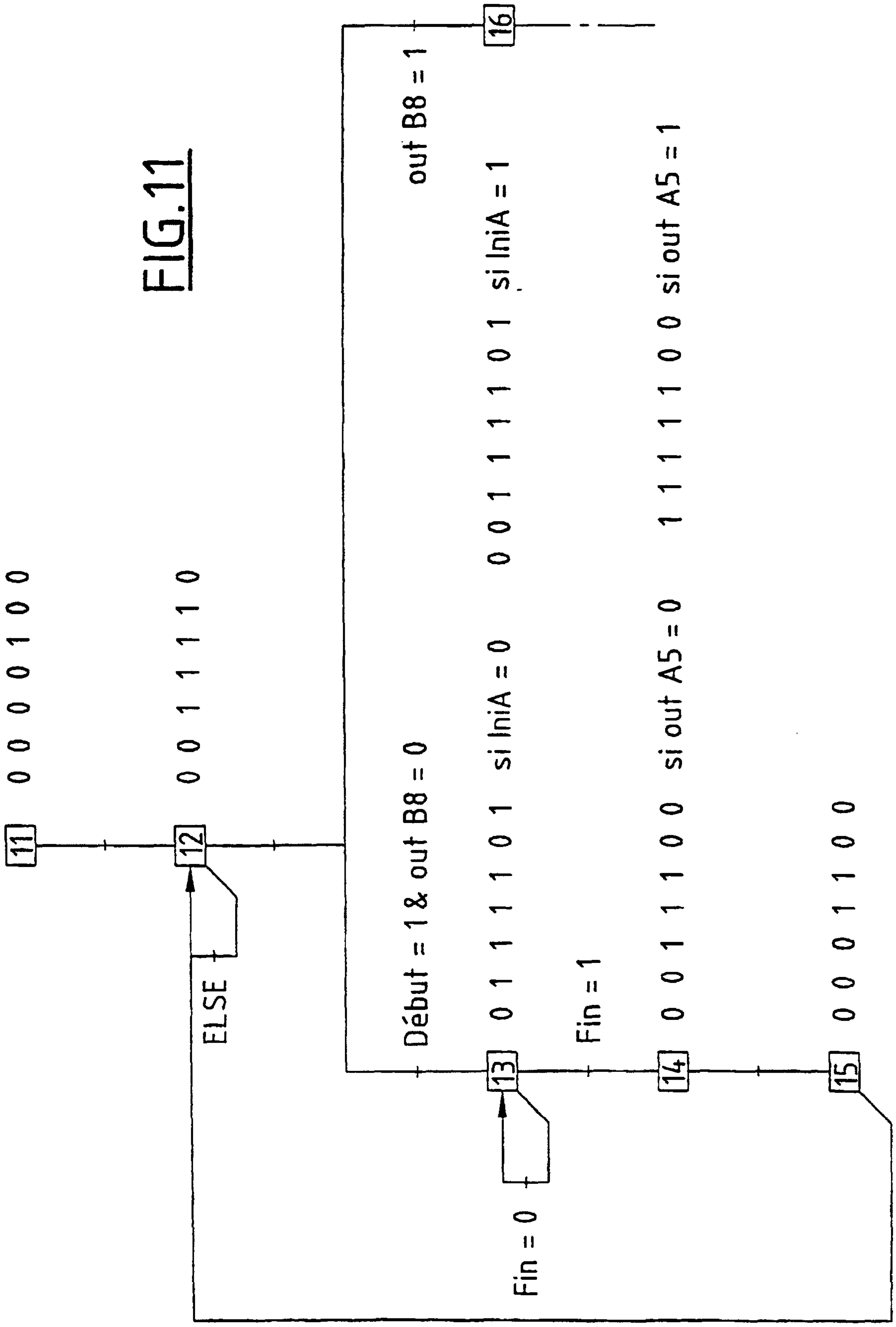
11
0 0 0 0 1 0 0
12
0 0 1 1 1 1 0
ELSE
Début = 1 & out B8 = 0
out B8 = 1
16
0 1 1 1 1 0 1 si IniA = 0
0 0 1 1 1 1 0 1 si IniA = 1
Fin = 1
13
Fin = 0
14
0 0 1 1 1 0 0 si out A5 = 0
1 1 1 1 1 0 0 si out A5 = 1
15
0 0 0 1 1 0 0

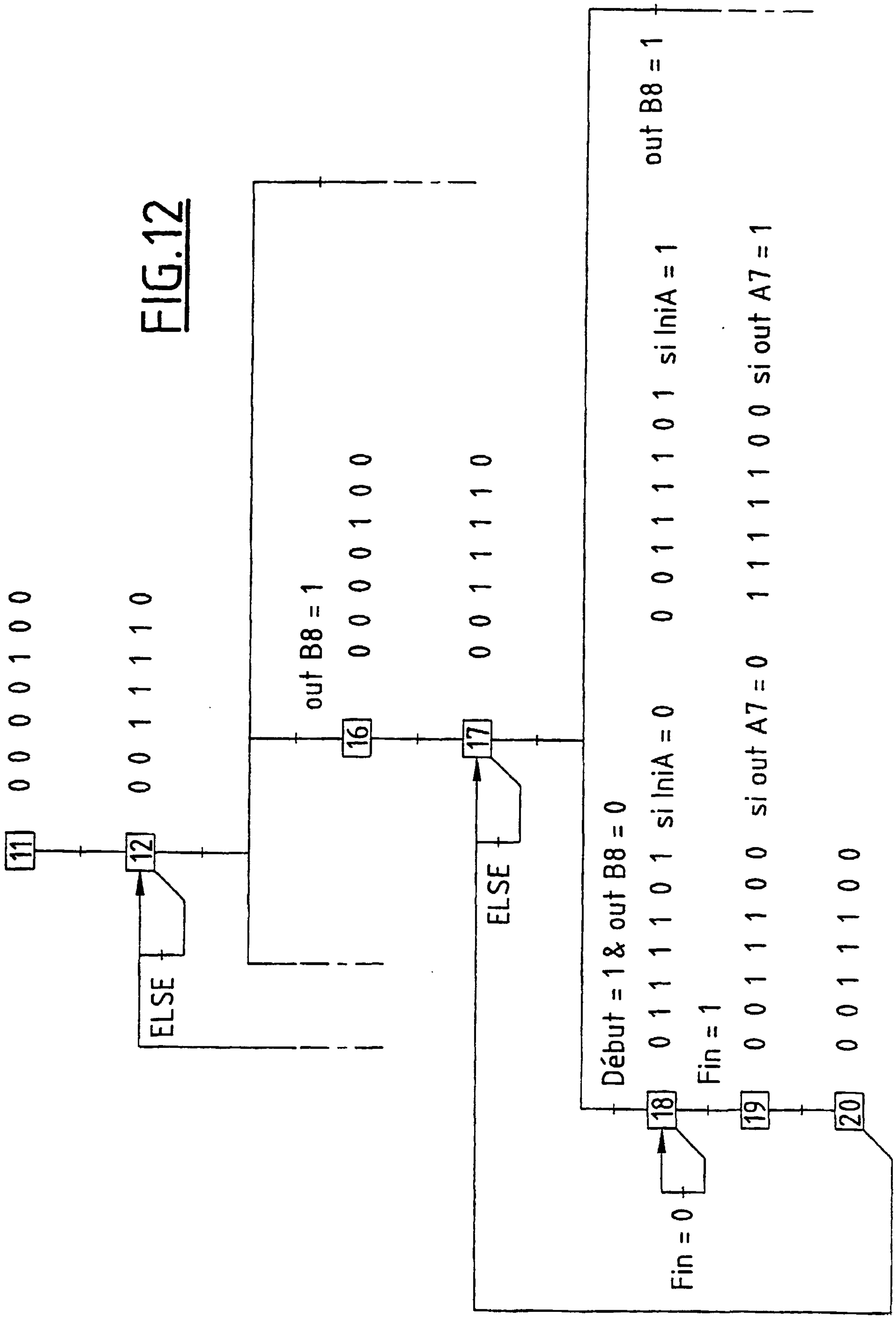
11
0 0 0 0 1 0 0
12
0 0 1 1 1 1 0
ELSE
out B8 = 1
16
0 0 0 0 1 0 0
17
0 0 1 1 1 1 0
ELSE
Début = 1 & out B8 = 0
18
0 1 1 1 1 0 1 si IniA = 0
0 0 1 1 1 1 0 1 si IniA = 1
out B8 = 1
Fin = 0
Fin = 1
19
0 0 1 1 1 0 0 si out A7 = 0
1 1 1 1 1 0 0 si out A7 = 1
20
0 0 1 1 1 0 0

FIG.12